# EUROPEAN PATENT APPLICATION

(11) **EP 2 194 584 A1**
(43) Date of publication of application: **09.06.2010**
(21) Application number: 08832895.0
(22) Date of filing: 17.09.2008
(51) Int. Cl.: H01L 31/042

(54) **SOLAR CELL, CONCENTRATOR PHOTOVOLTAIC MODULE, CONCENTRATOR PHOTOVOLTAIC UNIT AND SOLAR CELL MANUFACTURING METHOD**

(30) Priority: 26.09.2007 JP 2007249551; 28.01.2008 JP 2008016592
(71) Applicant: Sharp Kabushiki Kaisha, Osaka-shi, Osaka 545-8522 (JP)
(72) Inventor: OKAMOTO, Chikao, Osaka-shi Osaka 545-8522 (JP)
(74) Representative: Müller - Hoffmann & Partner
(86) International application number: PCT/JP2008/066748
(87) International publication number: WO 2009/041330

(57) **Abstract**

A solar cell (10) includes a solar cell element (11) that converts sunlight (Ls) concentrated by a concentrating lens (42) into electricity, a receiver substrate (20) on which the solar cell element (11) is placed, and a resin sealing portion (33) that resin-seals the solar cell element (11). The solar cell (10) further includes a reflecting member (32) that has an irradiation window (32f) that is disposed facing the solar cell element (11) and through which sunlight (Ls) is directed to the solar cell element (11), a light introducing window (32w) that is formed larger than the irradiation window (32f) and disposed facing the concentrating lens (42) and through which sunlight (Ls) is introduced, and a reflecting face (32r) that is formed between the irradiation window (32f) and the light introducing window (32w) and that reflects and guides sunlight (Ls) toward the solar cell element (11).

## Description

### Technical Field

The present invention relates to a solar cell including a reflecting member that has a reflecting face for reflecting and guiding concentrated sunlight to a solar cell element, a concentrating photovoltaic power generation module and a concentrating photovoltaic power generation unit that include such a solar cell, and a solar cell manufacturing method for manufacturing such a solar cell.

The present invention also relates to a solar cell including a reflecting member that has a light guide path that guides sunlight to a solar cell element and a reflecting face for reflecting sunlight to the solar cell element, a concentrating photovoltaic power generation module and a concentrating photovoltaic power generation unit that include such a solar cell, and a solar cell manufacturing method for manufacturing such a solar cell.

### Background Art

A non-concentrating, fixed flat plate structure in which a photovoltaic power generation module in which solar cell elements are laid closely together is installed on the roof or the like is most commonly used in photovoltaic power generation apparatuses. For such photovoltaic power generation apparatuses, a technique has been proposed to reduce the number of solar cell elements used, which is the most expensive among the members (components) constituting a photovoltaic power generation apparatus.

In other words, it has been proposed to concentrate sunlight by using an optical lens, reflecting mirror or the like and direct the concentrated sunlight to a solar cell element with a small area so as to increase the power generation per unit area of the solar cell element, as well as reducing the cost of solar cell elements (in other words, the cost of a photovoltaic power generation apparatus).

Generally speaking, the photoelectric conversion efficiency of a solar cell element is improved as the concentration magnification is increased. However, if the position of the solar cell element remains fixed, most sunlight enters obliquely, failing to make efficient use of the sunlight. In view of this, a sun-tracking concentrating photovoltaic power generation apparatus has been proposed that has a high concentration magnification and is configured to track the sun so as to always receive sunlight face on (see, for example, Patent Documents 1 to 3).

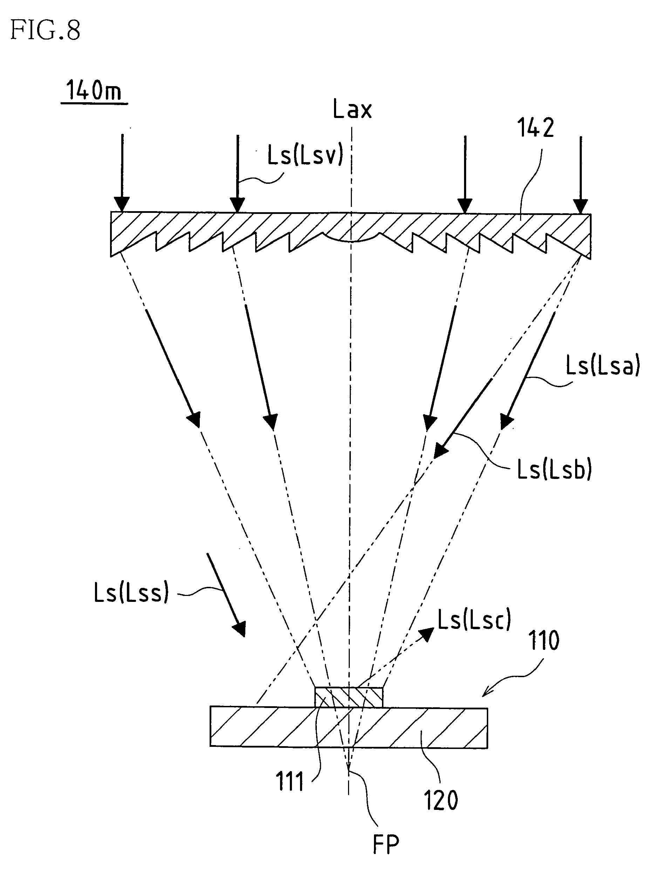

FIG. 8 is a cross-sectional view showing a configuration of a concentrating photovoltaic power generation module that is applied to a conventional sun-tracking concentrating photovoltaic power generation apparatus.

A concentrating photovoltaic power generation module 140m according to a conventional example includes a concentrating lens 142 for receiving and concentrating sunlight Lsv (sunlight Ls) that enters perpendicularly to the incident face in parallel with the optical axis Lax and a solar cell 110 for converting the sunlight Ls (sunlight Lsa) concentrated by the concentrating lens 142 into electricity. The solar cell 110 includes a solar cell element 111 for converting the sunlight Lsa concentrated onto a focal position FP by the concentrating lens 142 into electricity and a receiver substrate 120 on which the solar cell element 111 is placed.

A conventional sun-tracking concentrating photovoltaic power generation apparatus employs such a concentrating photovoltaic power generation module 140m, which can provide a high concentration magnification through the action of the concentrating lens 142.

A sun-tracking concentrating photovoltaic power generation apparatus having a high concentration magnification generally concentrates sunlight by using a concentrating lens 142. However, because the refraction by the concentrating lens 142 is slightly different for each of a wide variety of wavelengths of sunlight Ls, refraction that is significantly different from the normal may take place depending on the wavelength range (wavelengths in the short wavelength range, in particular, of the wavelength sensitivity range of the solar cell element 111), as a result of which sunlight Ls (sunlight Lsb) that is not concentrated onto the solar cell element 111 may be generated.

Accordingly, because the sunlight Ls in the above-described wavelength range is not concentrated by the concentrating lens 142, a problem arises in that the substantial amount of light that enters the solar cell element 111 decreases, reducing the power generation (output) of the solar cell element 111, and causing a loss.

In addition, because positional shift or the like occurs due to an alignment error between the concentrating lens 142 and the solar cell element 111 or the difference in temperature properties between the members that constitute the photovoltaic power generation module 140m, sunlight Ls (sunlight Lss) that is directed to a region other than the solar cell element 111 and thus is not concentrated may be generated, as is the case where different refraction takes place.

Accordingly, the sunlight Ls (sunlight Lsb and Lss) that is not concentrated onto the solar cell element 111 due to the difference in the refractive state depending on the wavelength range and the positional shift between constituent members poses a problem in that the substantial amount of light that enters the solar cell element 111 decreases, reducing the power generation (output) of the solar cell element 111, and causing a loss.

In addition, when irradiated with sunlight Lss deviated to a region other than the solar cell element 111, a problem arises in that the temperature of the members (e.g., an insulating film, wiring, etc. provided on the receiver substrate 120) irradiated with the sunlight Lss increases due to the heat energy of the deviated sunlight Lss, and the members may be burnt (damaged) in some cases.

Furthermore, there is a problem in that sunlight Lsc reflected from the solar cell element 111 because the solar cell element 111 cannot absorb all of the sunlight Lsa that has entered the solar cell element 111 constitutes a loss, as a result of which the power generation (output) of the solar cell element 111 is reduced.

The solar cell element 111 has another problem in that it generates heat due to concentrated sunlight Lsa and the power generation (output) is reduced as a result.
[Patent Document 1] United States Patent No. 5167724
[Patent Document 2] JP 2002-289897A
[Patent Document 3] JP 2003-258291A

### Disclosure of Invention

### Problems to be Solved by the Invention

The present invention has been conceived under such circumstances, and it is an object of the present invention to provide a high power output solar cell having improved reliability and weather-resisting properties that improves heat-resisting properties and light concentrating efficiency by including a reflecting member that improves the output by directing concentrated sunlight to a solar cell element without wasting it, and that reflects and guides deviated sunlight to the solar cell element.

It is another object of the present invention to provide a high power output concentrating photovoltaic power generation module having improved reliability and weather-resisting properties that includes a concentrating lens, and that improves heat-resisting properties and light concentrating efficiency by including a reflecting member that improves the output by directing concentrated sunlight to a solar cell element without wasting it, and that reflects and guides deviated sunlight to the solar cell element.

It is another object of the present invention to provide a high power output concentrating photovoltaic power generation unit having improved reliability and weather-resisting properties that includes a plurality of concentrating photovoltaic power generation modules, and that improves heat-resisting properties and light concentrating efficiency by including a reflecting member that improves the output by directing concentrated sunlight to a solar cell element without wasting it, and that reflects and guides deviated sunlight to the solar cell element.

It is another object of the present invention to provide a solar cell manufacturing method for manufacturing a solar cell for converting concentrated sunlight into electricity, wherein a reflecting member that improves the output by directing concentrated sunlight to a solar cell element without wasting it, and that reflects and guides deviated sunlight to the solar cell element is formed with a metal so as to form the reflecting member easily and highly accurately, with which highly efficient and reliable solar cells having superior heat-resisting properties are manufactured with good productivity.

It is another object of the present invention to provide a solar cell manufacturing method for manufacturing a solar cell for converting concentrated sunlight into electricity, wherein a reflecting member that improves the output by directing concentrated sunlight to a solar cell element without wasting it, and that reflects and guides deviated sunlight to the solar cell element is formed by covering glass with a metal film so as to form the reflecting member easily and highly accurately with reduced weight, with which highly efficient and reliable solar cells having superior heat-resisting properties are manufactured with good productivity.

It is another object of the present invention to provide a solar cell having improved heat-resisting properties, reliability and weather-resisting properties that improves the output properties of a solar cell element by including a reflecting member that directs concentrated sunlight to the solar cell element without wasting it, that improves heat dissipation from the front side of a receiver substrate, and that reflects deviated sunlight, thereby improving the power generation efficiency.

It is another object of the present invention to provide a concentrating photovoltaic power generation module having improved heat-resisting properties, reliability and weather-resisting properties that includes a solar cell for converting sunlight concentrated by a concentrating lens into electricity, wherein the power generation efficiency is improved by utilizing the sunlight concentrated by a concentrating lens without wasting it and improving the heat dissipation properties.

It is another object of the present invention to provide a concentrating photovoltaic power generation unit having improved heat-resisting properties, reliability and weather-resisting properties that includes a plurality of concentrating photovoltaic power generation modules arranged along an elongated frame, wherein the power generation efficiency is improved by utilizing the sunlight concentrated by a concentrating lens without wasting it and improving the heat dissipation properties.

It is another object of the present invention to provide a solar cell manufacturing method for manufacturing a solar cell for converting concentrated sunlight into electricity, wherein a reflecting member that has a light guide path and a reflecting face is disposed so as to be in contact with a receiver substrate with high accuracy, and a resin sealing portion is formed with high accuracy, so that the power generation efficiency is improved by utilizing the sunlight concentrated by a concentrating lens without wasting it and improving the heat dissipation properties, with which solar cells having improved heat-resisting properties, reliability and weather-resisting properties are manufactured with good productivity.

### Means for solving the Problems

A solar cell according to the present invention is a solar cell including a solar cell element that converts sunlight concentrated by a concentrating lens into electricity, a receiver substrate on which the solar cell element is placed, and a resin sealing portion that resin-seals the solar cell element, wherein the solar cell comprises a plate-like reflecting member that is disposed facing the solar cell element and the receiver substrate and that has an irradiation window through which sunlight is directed to the solar cell element, a light introducing window that is formed larger than the irradiation window and through which sunlight is introduced, and a reflecting face that is formed between the irradiation window and the light introducing window and that reflects and guides sunlight to the solar cell element, and the reflecting member is brought into contact with the resin sealing portion.

With this configuration, a light guide path for sunlight can be formed by the resin sealing portion and the reflecting member (reflecting face) that is disposed facing the solar cell element, as a result of which it is possible to prevent extraneous matter from being attached to the solar cell element and concentrate sunlight corresponding to a wavelength sensitivity range onto the solar cell element with high accuracy, and even when an alignment error occurs between the concentrating lens and the solar cell element, sunlight can be directed to the solar cell element with high accuracy, and therefore the light concentrating efficiency is improved, a reduction in the substantial amount of light that enters the solar cell element can be suppressed, and the power generation of the solar cell element can be improved. In addition, even when concentrated sunlight deviates due to a sun tracking error and is directed to a position different from the position of the solar cell element, the sunlight can be prevented from being directed to the receiver substrate and the temperature increase of the receiver substrate can be suppressed (reduced), as a result of which a highly efficient and inexpensive solar cell having improved heat-resisting properties, reliability and good weather-resisting properties can be obtained.

In the solar cell of the present invention, the irradiation window and the reflecting face are resin-sealed by the resin sealing portion.

With this configuration, because the light guide path formed by the reflecting face is charged (resin-sealed) with the resin sealing portion, even when extraneous matter is attached to the surface of the resin sealing portion, the position at which the extraneous matter is attached can be made an off focus position, and damage to the solar cell element can be prevented, as a result of which the light guide path for concentrated sunlight can be caused to act reliably, the accuracy of the amount of incident light can be stabilized, thereby stabilizing the power generation efficiency, and the mechanical connection between the reflecting member and the resin sealing portion can be stabilized.

In the solar cell of the present invention, the light introducing window and the resin sealing portion are flush with each other.

With this configuration, it is possible to prevent extraneous matter from intruding into the light guide path formed by the reflecting face, and maintain the light guide path with high accuracy, thereby stabilizing the power generation efficiency.

In the solar cell of the present invention, the light introducing window is covered with a cover member.

With this configuration, it is possible to prevent moisture and water from intruding into the resin sealing portion and protect the solar cell element, thereby improving the reliability of the solar cell.

In the solar cell of the present invention, the reflecting member is fixed to the receiver substrate via a reflecting member fixing means.

With this configuration, the alignment accuracy between the concentrating lens and the solar cell element can be improved, and the heat dissipation properties of the receiver substrate can be improved.

In the solar cell of the present invention, the reflecting member fixing means is a sealing frame portion that serves as a resin stopper when the resin sealing portion is formed by resin-sealing.

With this configuration, it is possible to form a reflecting member fixing means with ease.

In the solar cell of the present invention, the reflecting member is made of a metal.

With this configuration, it is possible to form a reflecting member having superior reflective properties easily and inexpensively with good mass productivity.

In the solar cell of the present invention, the reflecting face is mirror-finished.

With this configuration, it is possible to obtain a reflecting face with even more superior reflective properties.

In the solar cell of the present invention, the reflecting member is formed by covering glass with a metal film.

With this configuration, it is possible to form a reflecting member that is lightweight and has superior reflective properties easily and inexpensively with good mass productivity

A concentrating photovoltaic power generation module according to the present invention is a concentrating photovoltaic power generation module including a concentrating lens that concentrates sunlight and a solar cell that converts sunlight concentrated by the concentrating lens into electricity, wherein the solar cell is the solar cell according to the present invention.

With this configuration, it is possible to obtain a highly reliable concentrating photovoltaic power generation module having high efficiency and improved heat-resisting properties, wherein the light concentrating efficiency is improved, concentrated sunlight can be utilized without wasting it, and the influence of deviated sunlight is suppressed.

A concentrating photovoltaic power generation unit according to the present invention is a concentrating photovoltaic power generation unit including an elongated frame and a plurality of concentrating photovoltaic power generation modules that are arranged along the elongated frame, wherein the concentrating photovoltaic power generation modules are the concentrating photovoltaic power generation modules according to the present invention.

With this configuration, it is possible to obtain a highly reliable concentrating photovoltaic power generation unit having high efficiency and improved heat-resisting properties, wherein the light concentrating efficiency is improved, concentrated sunlight can be utilized without wasting it, and the influence of deviated sunlight is suppressed.

A solar cell manufacturing method according to the present invention is a solar cell manufacturing method for manufacturing a solar cell including a solar cell element that converts sunlight concentrated by a concentrating lens into electricity, a receiver substrate on which the solar cell element is placed, a resin sealing portion that resin-seals the solar cell element, and a plate-like reflecting member that is disposed facing the solar cell element and the receiver substrate and that has a reflecting face for reflecting and guiding sunlight to the solar cell element, the method including: a reflecting member preparing step of preparing the reflecting member by molding a metal; a reflecting member fixing step of fixing the reflecting member so as to face the solar cell element and the receiver substrate; a resin sealing step of forming the resin sealing portion by charging a sealing resin between the receiver substrate and the reflecting member via a light guide path formed by the reflecting face; and a surface flattening step of flattening the resin sealing portion formed in the light guide path so as to be flush with the reflecting member.

With this configuration, because the reflecting member having superior reflective properties can be formed and fixed easily and highly accurately, the process can be simplified, and a highly reliable solar cell having superior heat-resisting properties can be manufactured with good productivity.

A solar cell manufacturing method according to the present invention is a solar cell manufacturing method for manufacturing a solar cell including a solar cell element that converts sunlight concentrated by a concentrating lens into electricity, a receiver substrate on which the solar cell element is placed, a resin sealing portion that resin-seals the solar cell element, and a plate-like reflecting member that is disposed facing the solar cell element and the receiver substrate and that has a reflecting face for reflecting and guiding sunlight to the solar cell element, the method including: a reflecting member preparing step of preparing the reflecting member by molding glass and covering the glass with a metal film; a reflecting member fixing step of fixing the reflecting member so as to face the receiver substrate and the solar cell element; a resin sealing step of forming the resin sealing portion by charging a sealing resin between the receiver substrate and the reflecting member via a light guide path formed by the reflecting face; and a surface flattening step of flattening the resin sealing portion formed in the light guide path so as to be flush with the reflecting member.

With this configuration, it is possible to form and fix a lightweight reflecting member easily and highly accurately, as a result of which the process can be simplified and a highly reliable solar cell having superior heat-resisting properties can be manufactured with good productivity.

In the solar cell manufacturing method of the present invention, the reflecting member preparing step includes: a substrate glass forming step of forming substrate glass by molding glass; a metal film covering step of covering a surface of the substrate glass with a metal film; and a metal film heating step of heating the metal film.

With this configuration, because a stable metal film can be formed on the glass surface by covering the glass surface, a highly reliable solar cell manufacturing method can be obtained.

A solar cell according to the present invention is a solar cell including a solar cell element that converts sunlight concentrated by a concentrating lens into electricity, a receiver substrate on which the solar cell element is placed, and a resin sealing portion that resin-seals the solar cell element, wherein the solar cell includes a reflecting member that is disposed in contact with the receiver substrate in a periphery of the solar cell element and that has a light guide path that guides sunlight to the solar cell element and a reflecting face that defines the light guide path and that reflects sunlight to the solar cell element, and the resin sealing portion is formed by resin-sealing the light guide path.

With this configuration, because the light guide path defined by the reflecting member can be positioned with the solar cell element with high accuracy as a resin sealing portion, it is possible to obtain a solar cell having improved heat-resisting properties, reliability and weather-resisting properties that improves the output properties of a solar cell element by including a reflecting member that directs concentrated sunlight to the solar cell element without wasting it, that improves heat dissipation from the front side of a receiver substrate, and that reflects deviated sunlight, thereby improving the power generation efficiency.

In the solar cell of the present invention, the light guide path includes an irradiation window through which sunlight is directed to the solar cell element, a light introducing window that is formed larger than the irradiation window and through which sunlight is introduced, and a contact window that is formed larger than the irradiation window and that is in contact with the receiver substrate in a periphery of the solar cell element, and the reflecting face includes a light introducing-side reflecting face that is formed between the irradiation window and the light introducing window and that reflects and guides sunlight to the solar cell element and a substrate-side reflecting face that is formed between the irradiation window and the contact window and that reflects sunlight to the solar cell element.

With this configuration, the sunlight that has entered the light introducing window from the outside can be efficiently and highly accurately concentrated onto the irradiation window by the light introducing-side reflecting face and directed to the solar cell element, and the sunlight that has not been absorbed by the solar cell element and therefore has been reflected from the solar cell element side can be again reflected by the substrate-side reflecting face and directed to the solar cell element. Accordingly, efficient use of sunlight is achieved and the power generation and power generation efficiency can be further improved.

In the solar cell of the present invention, the receiver substrate has a metal base, and the reflecting member is brought into contact with the base.

With this configuration, the thermal resistance between the solar cell element and the reflecting member can be reduced, as a result of which the heat generated in the solar cell element and the receiver substrate can be efficiently dissipated to the outside via the base and the reflecting member.

In the solar cell of the present invention, the reflecting member includes a comb-like fin in a peripheral region of the light guide path on a side opposite to the side in contact with the receiver substrate.

With this configuration, because the heat dissipation properties of the reflecting member can be improved, the power generation efficiency of the solar cell can be improved, and lowering of the power generation can be prevented.

In the solar cell of the present invention, a thickness of the resin sealing portion located directly above the solar cell element is greater than or equal to a thickness of the reflecting member.

With this configuration, because extraneous matter can be prevented from being attached to the solar cell element, and the surface of the resin sealing portion can be made an off-focus position, the intensity of sunlight on the surface of the resin sealing portion can be suppressed, and the temperature increase on the surface of the resin sealing portion can be suppressed. Accordingly, when extraneous matter is attached to the surface of the resin sealing portion, damage and breakage to the solar cell element are prevented, as a result of which a highly safe and reliable solar cell can be obtained.

In the solar cell of the present invention, a surface of the resin sealing portion is a flat face.

With this configuration, because sunlight can be guided to the resin sealing portion with high accuracy, the incident accuracy of the sunlight on the solar cell element can be improved and stabilized, and the power generation efficiency can be stabilized.

In the solar cell of the present invention, a surface of the resin sealing portion is covered with a cover member.

With this configuration, because it is possible to prevent water from intruding into the resin sealing portion, a highly reliable solar cell that protects the solar cell element from water intrusion can be obtained.

In the solar cell of the present invention, the reflecting member is made of a metal.

With this configuration, because it is possible to easily and highly accurately form a reflecting member that include a light introducing-side reflecting face and a substrate-side reflecting face that are highly reflective, and that has high heat dissipation properties, the reflecting member can be formed with good mass productivity.

A concentrating photovoltaic power generation module according to the present invention is a concentrating photovoltaic power generation module including a concentrating lens that concentrates sunlight and a solar cell that converts sunlight concentrated by the concentrating lens into electricity, wherein the solar cell is the solar cell according to the present invention.

With this configuration, because the sunlight concentrated by the concentrating lens can be utilized without wasting it by the solar cell, and the heat dissipation properties can be improved, a concentrating photovoltaic power generation module having improved power generation efficiency, heat-resisting properties, reliability and weather-resisting properties can be obtained.

A concentrating photovoltaic power generation unit according to the present invention is a concentrating photovoltaic power generation unit including an elongated frame and a plurality of concentrating photovoltaic power generation modules that are arranged along the elongated frame, wherein the concentrating photovoltaic power generation modules are the concentrating photovoltaic power generation modules according to the present invention.

With this configuration, because the sunlight concentrated by the concentrating lens can be utilized without wasting it by the concentrating photovoltaic power generation module and the heat dissipation properties can be improved, a concentrating photovoltaic power generation unit having improved power generation efficiency, heat-resisting properties, reliability and weather-resisting properties can be obtained.

A solar cell manufacturing method according to the present invention is a solar cell manufacturing method for manufacturing a solar cell including a solar cell element that converts sunlight concentrated by a concentrating lens into electricity, a receiver substrate on which the solar cell element is placed, a resin sealing portion that resin-seals the solar cell element, and a reflecting member that is disposed in contact with the receiver substrate in a periphery of the solar cell element, the reflecting member having a light guide path that guides sunlight to the solar cell element and a reflecting face that defines the light guide path and that reflects sunlight to the solar cell element, the method including: a reflecting member preparing step of preparing the reflecting member by molding a metal; a reflecting member disposing step of disposing the reflecting member so as to be in contact with the receiver substrate in the periphery of the solar cell element; a resin sealing step of forming the resin sealing portion by charging a sealing resin into the light guide path; and a flat face forming step of forming a flat face by processing a surface of the resin sealing portion.

With this configuration, because the reflecting member that has a light guide path and a reflecting face can be disposed in contact with the receiver substrate with high accuracy, and the resin sealing portion can be formed with high accuracy, it is possible to manufacture, with good productivity, a solar cell having improved heat-resisting properties, reliability and weather-resisting properties wherein the power generation efficiency is improved by utilizing the sunlight concentrated by a concentrating lens without wasting it and improving the heat dissipation properties.

### Effects of the Invention

With a solar cell according to the present invention, because the solar cell includes a plate-like reflecting member that has a reflecting face for reflecting and guiding sunlight to a solar cell element and that is disposed facing the solar cell element and a receiver substrate, the light concentrating efficiency is improved, and the sunlight concentrated by a light-receiving lens can be directed to the solar cell element without wasting it. In addition, the deviated sunlight can be allowed to reflect, as a result of which the output properties of the solar cell can be improved, and an effect that improves the heat-resisting properties, reliability and weather-resisting properties can be obtained.

In addition, with a concentrating photovoltaic power generation module of the present invention, because the concentrating photovoltaic power generation module includes such a solar cell of the present invention, it is possible to obtain an effect of enabling a highly reliable concentrating photovoltaic power generation module having high efficiency and improved heat-resisting properties and weather-resisting properties, wherein the light concentrating efficiency is improved, concentrated sunlight can be utilized without wasting it, and the influence of deviated sunlight is suppressed.

In addition, with a concentrating photovoltaic power generation unit of the present invention, because the concentrating photovoltaic power generation unit includes a plurality of the concentrating photovoltaic power generation modules of the present invention, it is possible to obtain an effect of enabling a highly reliable concentrating photovoltaic power generation unit having high efficiency and improved heat-resisting properties and weather-resisting properties, wherein the light concentrating efficiency is improved, concentrated sunlight can be concentrated without wasting it, and the influence of deviated sunlight is suppressed.

In addition, according to a solar cell manufacturing method of the present invention, because a reflecting member is formed by using a metal, the reflecting member can be formed and fixed easily and highly accurately, and therefore it is possible to obtain an effect of simplifying the process and manufacturing, with good productivity, a highly reliable solar cell having superior heat-resisting properties.

In addition, according to a solar cell manufacturing method of the present invention, because the reflecting member is formed by covering glass with a metal film, a lightweight reflecting member can be formed and fixed easily and highly accurately, and therefore it is possible to obtain an effect of simplifying the process and manufacturing, with good productivity, a highly reliable solar cell having superior heat-resisting properties.

Furthermore, with a solar cell of the present invention, because the solar cell includes a reflecting member that is disposed in contact with a receiver substrate, and that includes a light guide path serving as a resin sealing portion and a reflecting face that reflects sunlight to a solar cell element, it is possible to obtain an effect in which concentrated sunlight can be focused and directed to the solar cell element without wasting it, heat dissipation from the front side of the receiver substrate can be improved, and deviated sunlight can be made to reflect, as a result of which the temperature increase of the receiver substrate can be suppressed (reduced), the output properties of the solar cell can be improved, thereby improving the power generation efficiency, and the heat-resisting properties, reliability and weather-resisting properties can be improved.

In addition, with the solar cell of the present invention, it is possible to obtain an effect in which even sunlight in a certain wavelength range, which has been difficult to be concentrated onto a solar cell element by a concentrating lens, can be concentrated onto the solar cell element with high accuracy by the light guide path, and a reduction in the substantial amount of light that enters the solar cell element due to positional shift caused by an alignment error between the concentrating lens and the solar cell element, the difference in temperature properties between the members that constitute the photovoltaic power generation module or the like can be prevented.

In addition, with a concentrating photovoltaic power generation module of the present invention, because the concentrating photovoltaic power generation module includes a concentrating lens for concentrating sunlight and a solar cell for converting the sunlight concentrated by the concentrating lens into electricity, and the solar cell is made up of the solar cell of the present invention, the sunlight concentrated by the concentrating lens can be utilized by the solar cell without wasting it and the heat dissipation properties can be improved, as a result of which it is possible to obtain an effect that improves the output properties and power generation efficiency, thereby improving the heat-resisting properties, reliability and weather-resisting properties.

In addition, with a concentrating photovoltaic power generation unit of the present invention, because the concentrating photovoltaic power generation unit includes an elongated frame and a plurality of concentrating photovoltaic power generation modules that are arranged along the elongated frame, and the concentrating photovoltaic power generation modules are made up of the concentrating photovoltaic power generation units of the present invention, the sunlight concentrated by the concentrating lens can be utilized by the concentrating photovoltaic power generation modules without wasting it and the heat dissipation properties can be improved, as a result of which it is possible to obtain an effect that improves the output properties and power generation efficiency, thereby improving the heat-resisting properties, reliability and weather-resisting properties.

In addition, according to a solar cell manufacturing method of the present invention, because a reflecting member that has a light guide path and a reflecting face can be disposed in contact with a receiver substrate with high accuracy, and a resin sealing portion can be formed with high accuracy, it is possible to obtain an effect that can manufacture, with good productivity, a solar cell having improved heat-resisting properties, reliability and weather-resisting properties that utilizes the sunlight concentrated by the concentrating lens without wasting it, and improves the heat dissipation properties, thereby improving the output properties and power generation efficiency.

### Brief Description of Drawings

[FIG. 1] FIG. 1 is a cross-sectional view showing a configuration of a solar cell and a concentrating photovoltaic power generation module according to Embodiment 1-1 of the present invention.
[FIG. 2] FIG. 2 is a plan view of the solar cell shown in FIG. 1 as viewed from the concentrating lens side.
[FIG. 3A] FIG. 3A is a process diagram illustrating a state of a solar cell in a step of a solar cell manufacturing method according to Embodiment 1-2 of the present invention shown in cross section taken along the line X-X of FIG. 2, and shows a state in a sealing frame portion forming step.
[FIG. 3B] FIG. 3B is a process diagram illustrating a state of the solar cell in a step of the solar cell manufacturing method according to Embodiment 1-2 of the present invention shown in cross section taken along the line X-X of FIG. 2, and shows a state in a reflecting member fixing step.
[FIG. 3C] FIG. 3C is a process diagram illustrating a state of the solar cell in a step of the solar cell manufacturing method according to Embodiment 1-2 of the present invention shown in cross section taken along the line X-X of FIG. 2, and shows a state in a resin sealing step.
[FIG. 3D] FIG. 3D is a process diagram illustrating a state of the solar cell in a step of the solar cell manufacturing method according to Embodiment 1-2 of the present invention shown in cross section taken along the line X-X of FIG. 2, and shows a state in a cover member placing step.
[FIG. 4] FIG. 4 is a perspective view schematically showing a configuration of a concentrating photovoltaic power generation unit according to Embodiment 1-3 of the present invention and Embodiment 2-3 of the present invention.
[FIG. 5] FIG. 5 is a cross-sectional view showing a configuration of a solar cell and a concentrating photovoltaic power generation module according to Embodiment 2-1 of the present invention.
[FIG. 6] FIG. 6 is a plan view of the solar cell shown in FIG. 5 as viewed from the concentrating lens side.
[FIG. 7A] FIG. 7A is a process diagram illustrating a solar cell manufacturing method according to Embodiment 2-2 of the present invention, and shows a state in which a solar cell element is placed on a receiver substrate in cross section taken along the line X-X of FIG. 6.
[FIG. 7B] FIG. 7B is a process diagram illustrating the solar cell manufacturing method according to Embodiment 2-2 of the present invention, and shows a state in which a reflecting member is placed on the receiver substrate in cross section taken along the line X-X of FIG. 6.
[FIG. 7C] FIG. 7C is a process diagram illustrating the solar cell manufacturing method according to Embodiment 2-2 of the present invention, and shows a state in which a resin sealing portion is formed in a light guide path of the reflecting member in cross section taken along the line X-X of FIG. 6.
[FIG. 7D] FIG. 7D is a process diagram illustrating the solar cell manufacturing method according to Embodiment 2-2 of the present invention, and shows a state in which the resin sealing portion is covered with a cover member in cross section taken along the line X-X of FIG. 6.
[FIG. 8] FIG. 8 is a cross-sectional view showing a configuration of a concentrating photovoltaic power generation module that is applied to a conventional sun-tracking concentrating photovoltaic power generation apparatus.

### Description of Reference Numerals

- 10: Solar Cell
- 11: Solar Cell Element
- 20: Receiver Substrate
- 21: Bonding Portion
- 32: Reflecting Member
- 32f: Irradiation Window
- 32r: Reflecting Face
- 32w: Light Introducing Window
- 33: Resin Sealing Portion
- 34: Sealing Frame Portion (Reflecting Portion Fixing Means)
- 35: Light Guide Path
- 36: Cover Member
- 40: Concentrating photovoltaic power generation Unit
- 40m: Concentrating photovoltaic power generation Module
- 42: Concentrating Lens
- 44: Elongated Frame
- 62: Reflecting Member
- 62f: Irradiation Window
- 62h: Fin
- 62r: Reflecting Face
- 62rb: Substrate-Side Reflecting Face
- 62rw: Light Introducing-Side Reflecting Face
- 62t: Contact Window
- 62w: Light Introducing Window
- 63: Resin Sealing Portion
- 65: Light Guide Path
- 66: Cover Member
- Af: Light Concentration Region
- Lax: Optical Axis
- Ls, Lsa,: Lsb, Lsc, Lss, Lsv Sunlight
- Roth: Horizontal Rotation
- Rotv: Vertical Rotation

### Best Mode for Carrying Out the Invention

Hereinafter, embodiments of the present invention will be described with reference to the drawings.

### Embodiment 1-1

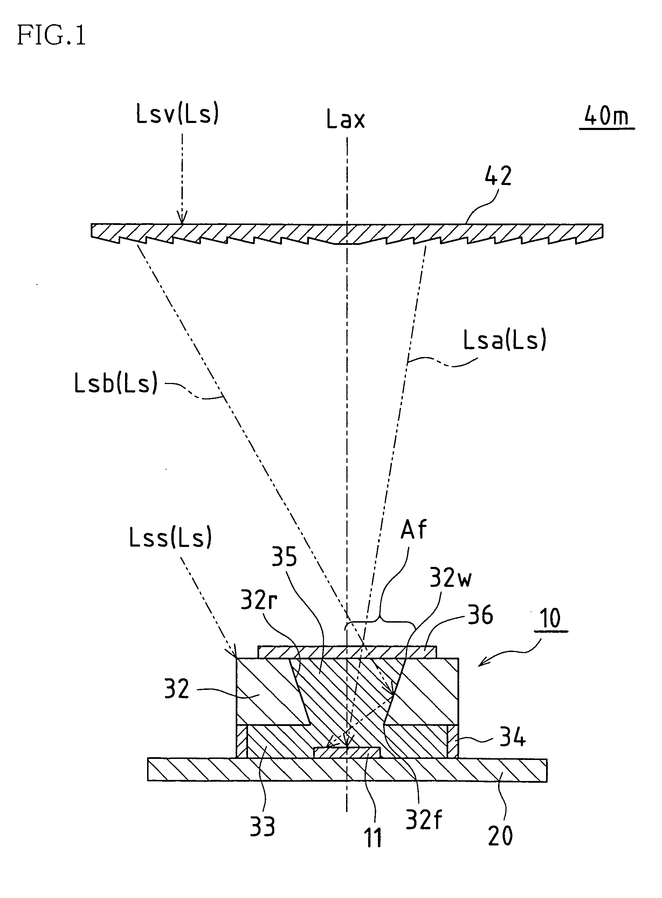

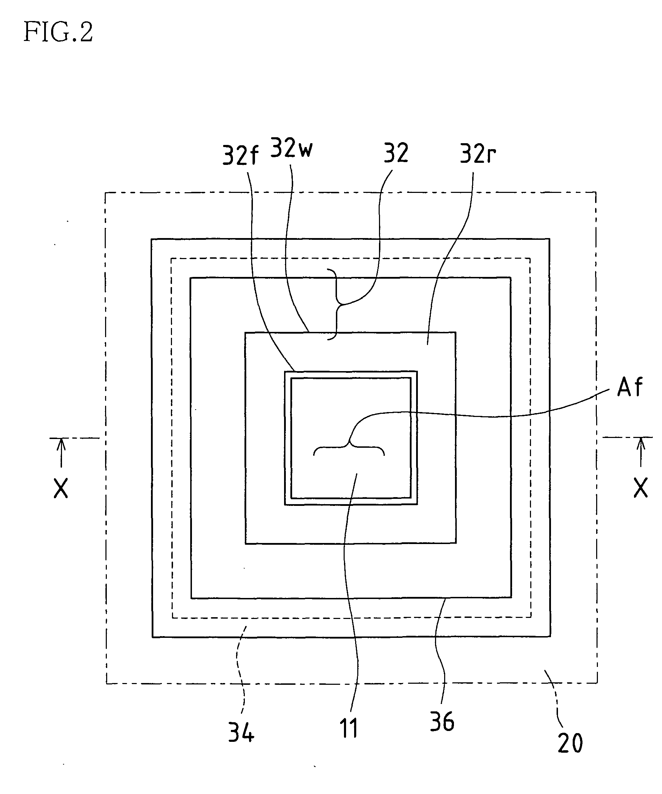

A solar cell and a concentrating photovoltaic power generation module according to Embodiment 1-1 will be described with reference to FIGS. 1 and 2.

FIG. 1 is a cross-sectional view showing a configuration of a solar cell and a concentrating photovoltaic power generation module according to Embodiment 1-1 of the present invention. FIG. 2 is a plan view of the solar cell shown in FIG. 1 as viewed from the concentrating lens side.

A solar cell 10 according to the present embodiment includes a solar cell element 11 that converts sunlight Ls (sunlight Lsa) concentrated by a concentrating lens 42 into electricity, a receiver substrate 20 on which the solar cell element 11 is placed, and a resin sealing portion 33 that seals the solar cell element 11 with resin.

The concentrating lens 42 is configured so as to face the sun by the action of a sun-tracking mechanism (not shown). Accordingly, sunlight Ls enters perpendicularly to the incident face of the concentrating lens 42 in the direction parallel to the optical axis Lax as sunlight Lsv.

The sunlight Lsv is refracted and concentrated by the concentrating lens 42, and the most sunlight is directed directly to the solar cell element 11 as sunlight Lsa. However, because the wavelength range of sunlight Ls includes a wide variety of different wavelengths, a certain range of wavelengths (wavelengths in the short wavelength range, in particular, of the wavelength sensitivity range of the solar cell element 11) refracts differently from the normal refraction state, as a result of which sunlight Lsb that is not directed directly to the solar cell element 11 is generated.

In the present embodiment, a configuration is employed in which the sunlight Lsb that is not directed directly to the solar cell element 11 is reflected and guided by a reflecting member 32 so as to direct the sunlight Lsb to the solar cell element 11. Specifically, the solar cell 10 includes a plate-like reflecting member 32 that has a reflecting face 32r and that is disposed facing the solar cell element 11 and the receiver substrate 20.

In other words, the reflecting member 32 includes an irradiation window 32f that is disposed facing the solar cell element 11 and through which sunlight Ls (sunlight Lsa and sunlight Lsb) is directed to the solar cell element 11, a light introducing window 32w that is formed larger than the irradiation window 32f and disposed facing the concentrating lens 42 and through which sunlight Ls (sunlight Lsa and sunlight Lsb) is introduced, and a reflecting face 32r that is formed between the irradiation window 32f and the light introducing window 32w and that reflects and guides sunlight Ls to the solar cell element 11.

Because the reflecting member 32 has the reflecting face 32r, the reflecting member 32 can concentrate sunlight Ls without wasting it to improve the light concentrating efficiency as well as reflecting deviated sunlight Ls (e.g., sunlight Lsb) to the solar cell element 11.

Accordingly, a light guide path 35 for sunlight Ls can be formed by the reflecting member 32 (the reflecting face 32r) and the resin sealing portion 33, as a result of which it is possible to prevent extraneous matter from being attached to the solar cell element 11 and concentrate sunlight Ls that corresponds to the wavelength sensitivity range to the solar cell element 11 with high accuracy. In addition, even when concentrated sunlight Ls deviates due to an alignment error between the concentrating lens 42 and the solar cell element 11 or sun tracking error, it is possible to direct the sunlight Ls to the solar cell element 11 with high accuracy, so a reduction in the substantial amount of light that enters the solar cell element 11 can be suppressed and the power generation of the solar cell element 11 can be improved.

It is desirable that the thickness of the reflecting member 32 (the height from the receiver substrate 20) is set such that the irradiation intensity of sunlight Ls at the position of the light introducing window 32w is reduced to, for example, approximately 0.35 kW/m² or less, and that the heat-resisting properties of the reflecting member 32 and the resin sealing portion 33 can be secured.

The solar cell element 11 is made of an inorganic material such as, for example, Si, GaAs, CuInGaSe or CdTe. As the structure of the solar cell element 11, a variety of types of structures can be used such as a single-junction type solar cell, a monolithic multijunction type solar cell, and a mechanical stack type in which various solar cells having different wavelength sensitivity ranges are connected.

It is desirable that the external size of the solar cell element 11 is from approximately several millimeters to approximately 20 mm from the viewpoint of a reduction in the solar cell material used, processing cost, ease of processing, simplification, and so on.

In addition, in order to reduce the light reflection coefficient in the wavelength sensitivity range of the solar cell element 11, a suitable anti-reffection film or the like may be provided on the surface of the solar cell element 11. Furthermore, a UV reflective film, an infrared reflective film or the like that reflects light of wavelengths other than the wavelength sensitivity range of the solar cell element 11 may be provided.

In the receiver substrate 20, desired wiring (a connection pattern that is connected to the electrodes (not shown) of the solar cell element 11 and that performs output to the outside, or a connection pattern for connecting solar cells 10 in series or in parallel, not shown) is formed on a base such as an aluminum plate or copper plate with an appropriate insulating layer interposed therebetween.

In other words, a configuration is adopted in which the current generated by the solar cell element 11 is output to the outside of the solar cell 10 via the wiring formed in the receiver substrate 20 as appropriate. Because the wiring formed in the receiver substrate 20 is required to secure highly reliable insulation capabilities, a configuration, for example, is adopted in which insulation is provided by covering the connection pattern formed of a copper foil with an insulating film made of an organic material or the like.

The reflecting member 32 is brought into contact with the resin sealing portion 33, and the irradiation window 32f and the reflecting face 32r are resin-sealed by the resin sealing portion 33. The resin sealing portion 33 is formed of an insulating resin charged in the space between the solar cell element 11 and a cover member 36 (the space between the receiver substrate 20 and the reflecting member 32 that is disposed facing the receiver substrate 20, and the space of the light guide path 35 that is formed by the reflecting face 32r). For example, the resin sealing portion 33 is formed, using a transparent silicone resin, so as to guide and direct the sunlight Ls that has passed through the cover member 36 to the solar cell element 11.

Because the light guide path 35 formed by the reflecting face 32r is charged (resin-sealed) with the resin sealing portion 33, even if extraneous matter is attached to the surface of the resin sealing portion 33, the position at which the extraneous matter is attached can be made an off-focus position so as to prevent damage to the solar cell element 11, as a result of which the light guide path 35 for concentrated sunlight Ls can be caused to act reliably, the accuracy of the amount of incident light can be stabilized, thereby stabilizing the power generation efficiency, and the mechanical connection between the reflecting member 32 and the resin sealing portion 33 can be stabilized.

In addition, because the reflecting member 32 is disposed so as to correspond to the outer peripheral region of the solar cell element 11 and face the receiver substrate 20, even when concentrated sunlight Ls deviates due to a sun tracking error, and the sunlight Ls (sunlight Lss) is directed to a position different from the position of the solar cell element 11, it is possible to prevent the sunlight Lss from being directly directed to the receiver substrate 20, suppressing (reducing) the increase of the temperature of the receiver substrate 20, as a result of which it is possible to obtain a highly efficient and inexpensive solar cell 10 having improved heat-resisting properties, reliability and good weather-resisting properties.

The light introducing window 32w and the resin sealing portion 33 (the top face) are flush with each other. Accordingly, it is possible to prevent extraneous matter from intruding into the light guide path 35 formed by the reflecting face 32r, as a result of which the light guide path 35 can be maintained with high accuracy and the power generation efficiency can be stabilized.

The light introducing window 32w is covered with a cover member 36. Accordingly, moisture and water can be prevented from intruding into the resin sealing portion 33, making it possible to protect the solar cell element 11 from the external environment and improving the reliability of the solar cell 10. In other words, the cover member 36 is made of, for example, a glass plate so as to secure heat-resisting properties and moisture-resisting properties and to improve weather-resisting properties.

As described above, the solar cell 10 includes the resin sealing portion 33 that resin-seals the solar cell element 11, the reflecting member 32 that has the reflecting face 32r, and the cover member 36 that covers the reflecting member 32 (the light introducing window 32w), which constitute the light guide path 35.

Accordingly, sunlight Lsa that has been refracted and concentrated by the concentrating lens 42 directly enters the solar cell element 11, whereas sunlight Lsb that has not been concentrated by the concentrating lens 42 is reflected and refracted by the reflecting member 32 (the reflecting face 32r) and then enters the solar cell element 11. In other words, sunlight Lsb, which was a loss in conventional technology, can be made to enter the solar cell element 11, as a result of which it is possible to reduce the loss of the solar cell 10, achieving high efficiency.

The reflecting face 32r (the irradiation window 32f and the light introducing window 32w) of the reflecting member 32 forms a region (the light guide path 35) that reflects sunlight Lsb to cause it to enter the solar cell element 11 (effective incident face region). Accordingly, in a state in which the concentrating lens 42 is in the normal position, even sunlight Lsb resulting from a certain range of wavelengths (e.g., wavelengths in the short wavelength range described above) can be reliably concentrated onto the solar cell element 11. It is desirable that the irradiation window 32f and the light introducing window 32w are formed to have a similar shape as that of the solar cell element 11 (effective incident face region).

Here, a configuration is employed in which sunlight Ls is concentrated onto the solar cell element 11 by a sun-tracking mechanism, but a situation can occur in which, for example, the sunlight deviates due to the occurrence of a sun tracking error or an alignment error in the optical system, and the light concentration spot is shifted from the light concentration region Af.

In other words, a situation can occur in which deviated sunlight Ls (sunlight Lss) is directed to the solar cell 10. Hereinafter, shifting of the light concentration spot due to a sun tracking error, alignment error, variation of light intensity or the like will also be referred to simply as shifting due to a sun tracking error (sun tracking error, etc).

Because the reflecting member 32 is disposed corresponding to the outside of the light concentration region Af that is set with respect to sunlight Lsa and sunlight Lsb that have been concentrated toward the solar cell element 11 (effective incident face region), even if sunlight Lss is generated, the sunlight Lss can be reflected.

Accordingly, even when concentrated sunlight Lsa or sunlight Lsb deviates due to, for example, a sun tracking error or the like, and sunlight Lss that is directed to a position (the outside of the light concentration region At) different from the position (effective incident face region) of the solar cell element 11 is generated, it is possible to prevent the sunlight Lss from being directed to the receiver substrate 20.

In other words, because the reflecting member 32 is disposed so as to face the receiver substrate 20 at the outside of the light concentration region Af, sunlight Lss can be prevented from being directed to the receiver substrate 20, and the increase of the surface temperature of the receiver substrate 20 can be suppressed, as a result of which it is possible to prevent burnout of the members disposed on the surface of the receiver substrate 20.

Because the wiring formed on the surface of the receiver substrate 20 is made of an organic member having low heat-resisting properties as described above, if irradiated with sunlight Lss, the organic member may be damaged, leading to damage to the wiring, and the reliability of the solar cell 10 may be reduced. However, because the reflecting member 32 is provided, it is possible to prevent sunlight Lss from being directly directed to the receiver substrate 20 (wiring) and avoid damage to the wiring, and the like.

Accordingly, by disposing the reflecting member 32, even in the case of a high concentration magnification such as 600 SUN (1 SUN = 100 mW/cm²) or more, it is possible to prevent the wiring (organic member) and the like of the receiver substrate 20 from being burnt, as a result of which a highly efficient and inexpensive solar cell 10 having improved heat-resisting properties, good reliability and weather-resisting properties can be obtained.

The reflecting member 32 is made of, for example, a metal. Accordingly, sunlight Ls can be effectively reflected. The reflecting member 32 with superior reflectivity can be formed easily and inexpensively with good mass productivity by forming it with a metal.

Because the reflecting member 32 can be provided only by disposing the irradiation window 32f directly on the solar cell element 11, and no other members are necessary, it can be formed inexpensively. Also, the sunlight Lsb, which was a loss in conventional technology, can be made to enter the solar cell element 11, so that the efficiency of the solar cell element 11 can be improved.

In addition, because the reflecting member 32 prevents excessive irradiation of the receiver substrate 20 with sunlight Lss, the temperature increase that causes decreased efficiency in the solar cell element 11 can be suppressed (reduced). In other words, the temperature increase of the solar cell element 11 and the temperature increase of the receiver substrate 20 are suppressed to prevent lowering of the power generation efficiency of the solar cell element 11 and burnout of the members disposed on the receiver substrate 20, as a result of which heat-resisting properties are improved and lowering of the power generation amount is prevented.

The reflecting member 32 may be formed by covering glass with a metal film, instead of using a metal. By using glass, a lightweight reflecting member 32 having superior reflective properties can be formed easily and inexpensively with good mass productivity.

The reflecting member 32 is fixed to the receiver substrate 20 via a sealing frame portion 34 (reflecting member fixing means). Accordingly, the accuracy of alignment between the concentrating lens 42 and the solar cell element 11 can be improved, and the heat dissipation properties of the receiver substrate 20 can be improved.

The sealing frame portion 34 is formed in advance as a resin stopper when forming the resin sealing portion 33 by resin-sealing. Accordingly, because the sealing frame portion 34 is used as a reflecting member fixing means, it is possible to form the reflecting member fixing means with ease.

The sealing frame portion 34 (reflecting member fixing means) can be formed by disposing, for example, a metal frame or plastic frame, but it is desirable that the sealing frame portion 34 is formed with an adhesive resin that can bond the reflecting member 32.

It is also possible to form a frame-shaped leg portion in the reflecting member 32 and bond the leg portion to the receiver substrate 20 so as to form the reflecting member fixing means and the reflecting member 32 as a single body With this configuration, the number of components and the number of process steps can be reduced, and the heat dissipation properties of the receiver substrate 20 can be further improved.

In addition, a concentrating photovoltaic power generation module 40m according to the present embodiment includes a concentrating lens 42 for receiving and concentrating sunlight Ls and a solar cell element 11 (solar cell 10) for converting sunlight Ls concentrated by the concentrating lens 42 into electricity.

With this configuration, because a highly efficient solar cell 10 having superior heat-resisting properties is included, a highly reliable concentrating photovoltaic power generation module 40m having improved heat-resisting properties and light concentrating efficiency can be formed. In other words, a highly reliable and efficient concentrating photovoltaic power generation module 40m having improved heat-resisting properties wherein concentrated sunlight Ls can be utilized without wasting it can be obtained.

For a solar cell element 11 used in the concentrating photovoltaic power generation module 40m, because it is required to have high efficiency and practical usefulness in particular, it is desirable to use an InGaP/GaAs/Ge triple-junction solar cell element, an AlGaAs/Si solar cell element, or a monolithic multijunction solar cell element.

In order to provide efficient light concentration of the concentrating lens 42, the surface of the solar cell element 11 for converting sunlight Ls into electricity is made flat and disposed in parallel with the incident face and emitting face of the cover member 36 so as to be a plane orthogonal to the optical axis Lax.

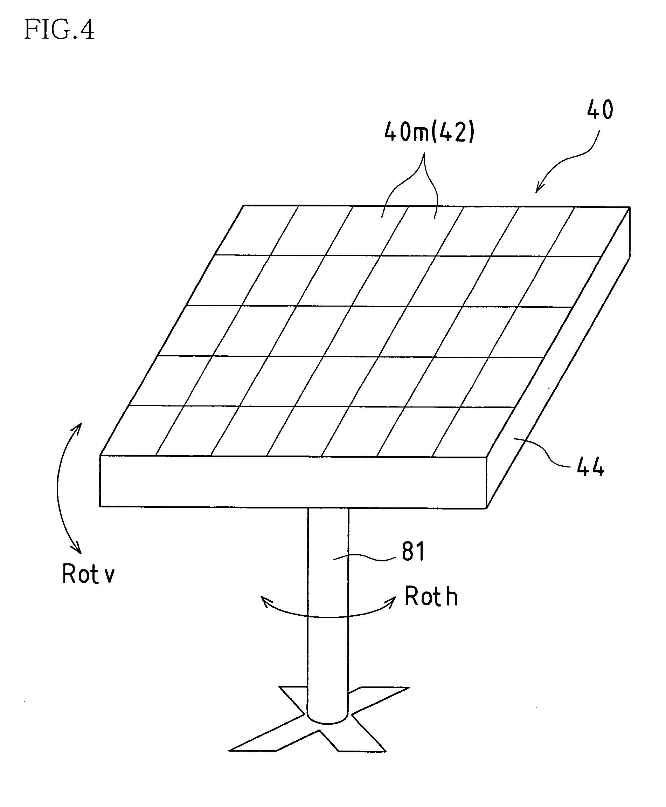

The concentrating lens 42 can be a biconvex lens, a planoconvex lens, a Fresnel lens or the like. From the viewpoint of weight, cost, ease of handling in the use environment and the like, it is desirable that the incident face that receives sunlight Ls is flat, and that the emitting face from which the sunlight Ls is directed to the solar cell element 11 has the shape of a Fresnel lens having a substantially triangular cross section. The concentrating lens 42 may also be configured by arranging a plurality of the same optical systems in an array to form a single body (see FIG. 4).

It is preferable that the material for the concentrating lens 42 has a high transmittance at the sensitivity wavelength light of the solar cell element 11 and weather-resisting properties. For example, it is possible to use a thin plate glass, weather-resisting properties grade acrylic resin, polycarbonate or the like generally used in conventional solar cell modules (photovoltaic power generation systems) or the like. The material for the concentrating lens 42 is not limited to those listed above, and it can be formed from a plurality of layers of such materials. Also, a suitable ultraviolet-absorbing agent can be added to such materials for the purpose of preventing ultraviolet deterioration of the concentrating lens 42 itself and other members.

### Embodiment 1-2

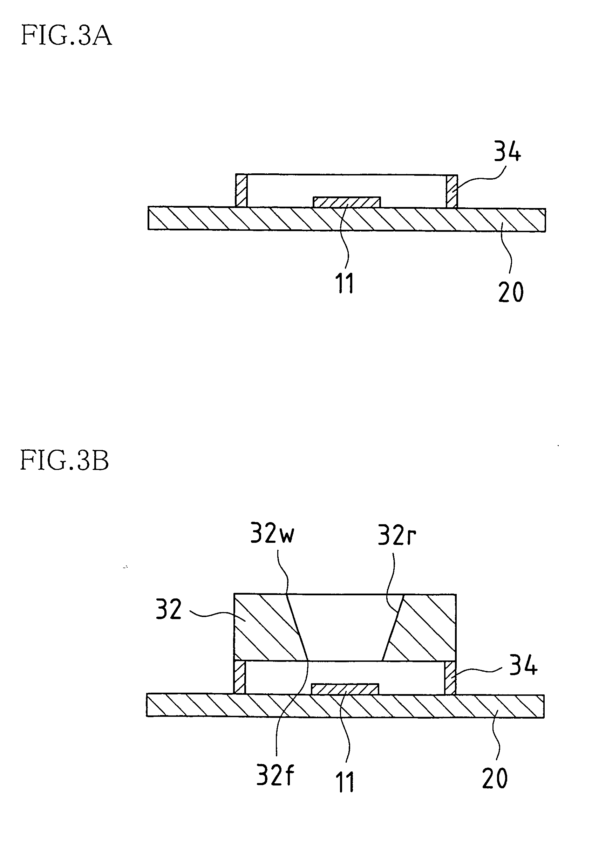

A solar cell manufacturing method according to Embodiment 1-2 will be described with reference to FIGS. 3A to 3D. In other words, a solar cell manufacturing method for manufacturing the solar cell 10 according to Embodiment 1-1 will be described as Embodiment 1-2.

FIGS. 3A to 3D are process diagrams illustrating a state of a solar cell in respective steps of a solar cell manufacturing method according to Embodiment 1-2 of the present invention shown in cross section taken along the line X-X of FIG. 2. FIG. 3A shows a state in a sealing frame portion forming step, and FIG. 3B shows a state in a reflecting member fixing step.

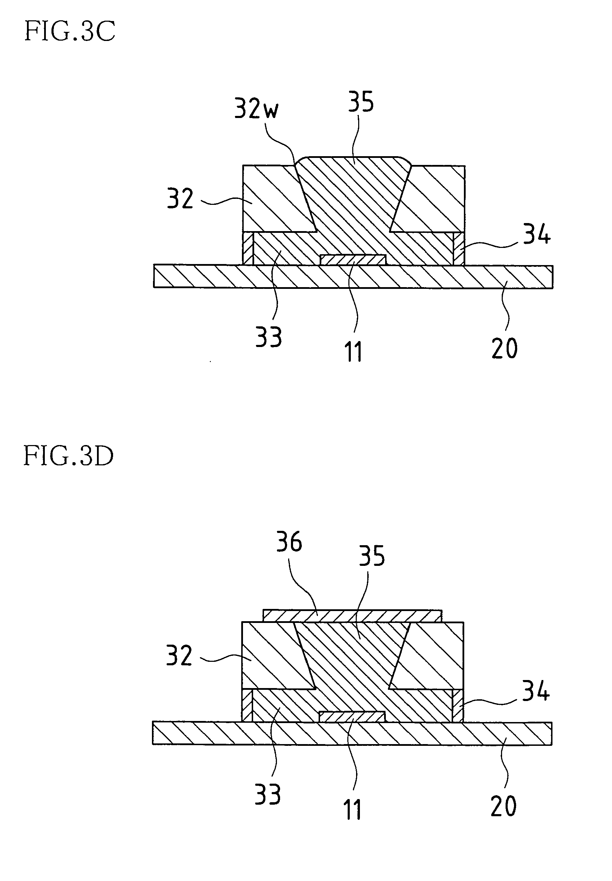

FIG. 3C shows a state in a resin sealing step, and FIG. 3D shows a state in a cover member placing step.

First, a reflecting member 32 is prepared by molding a metal (a reflecting member preparing step, not shown). The reflecting member 32 is formed by opening an irradiation window 32f and a light introducing window 32w in a metal plate to form a reflecting face 32r. In order to allow sunlight Ls to efficiently enter the solar cell element 11, it can be produced by die casting, or by hollowing a metal plate, such that the reflecting face 32r is formed at an incline.

The incline of the reflecting face 32r can be, for example, approximately the same as the incline of a straight line connecting an end portion of the concentrating lens 42 and an end portion of the solar cell element 11. The amount of reflection can be adjusted by adjusting the degree of incline, and thus it is desirable to set an appropriate degree according to the shape of the concentrating photovoltaic power generation module 40m applied. With this configuration, it is possible to form a reflecting member 32 having superior reflective properties.

Next, in order to increase the reflection coefficient of the reflecting member 32 (reflecting face 32r), the reflecting face 32r is mirror-finished. After that, a metal film may be further formed and laminated by a vacuum deposition method, a sputtering method or a plating method. With this configuration, it is possible to form a reflecting face 32r with even more superior reflective properties.

Next, a sealing frame portion 34 (reflecting member fixing means) is formed on a receiver substrate 20 (a sealing frame portion forming step or reflecting member fixing means forming step, see FIG. 3A). As described in Embodiment 1-1, the sealing frame portion 34 can be formed by forming and disposing a metal frame or plastic frame, but it is desirable that the sealing frame portion 34 is formed with a resin or adhesive that can bond the reflecting member 32. In the case of forming the sealing frame portion 34 and the reflecting member 32 as a single body, the sealing frame portion forming step (the reflecting member fixing means forming step) is combined with the next reflecting member fixing step.

After that, the reflecting member 32 is placed on the sealing frame portion 34 and bonded and fixed (a reflecting member fixing step, see FIG. 3B). At this time, it is necessary to place the reflecting member 32 on the sealing frame portion 34 such that the center of the irradiation window 32f of the reflecting member 32 and the center of the solar cell element 11 (effective incident face region) match. In other words, the reflecting member 32 is placed so as to face the receiver substrate 20 and the solar cell element 11, and fixed.
Next, a resin sealing portion 33 is formed by charging a sealing resin between the receiver substrate 20 and the reflecting member 32 via a light guide path 35 (light introducing window 32w) formed by the reflecting face 32r (a resin sealing step, see FIG. 3C). In other words, by forming the resin sealing portion 33, the solar cell element 11 as well as the light guide path 35 are resin-sealed.

After that, the resin sealing portion 33 formed in the light guide path 35 is flattened so as to be flush with the reflecting member 32 (light introducing window 32w) (a surface flattening step, not shown), and a cover member 36 is bonded onto the resin sealing portion 33 and the reflecting member 32 by using the same type of adhesive as the resin sealing portion 33 (a cover member placing step, see FIG. 3D). In other words, the surface of the resin charged in order to obtain stable and highly reliable output properties is flattened and the cover member 36 that protects the solar cell element 11 from moisture and water is placed so as to shield the interface between the light introducing window 32w and the resin sealing portion 33 from the external atmosphere.

As described above, the solar cell manufacturing method for manufacturing a solar cell 10 according to the present embodiment relates to a method for manufacturing a solar cell 10 that includes a solar cell element 11 that converts sunlight Ls concentrated by the concentrating lens 42 into electricity, a receiver substrate 20 on which the solar cell element 11 is placed, a resin sealing portion 33 that resin-seals the solar cell element 11, and a plate-like reflecting member 32 that has a reflecting face 32r for reflecting and guiding sunlight Ls to the solar cell element 11 and that is disposed facing the solar cell element 11 and the receiver substrate 20, and the method involves the following steps.

Specifically, the solar cell manufacturing method involves a reflecting member preparing step of preparing the reflecting member 32 by molding a metal, a reflecting member fixing step of fixing the reflecting member 32 so as to face the solar cell element 11 and the receiver substrate 20, a resin sealing step of forming the resin sealing portion 33 by charging a sealing resin between the receiver substrate 20 and the reflecting member 32 via a light guide path 35 (light introducing window 32w) formed by the reflecting face 32r, and a surface flattening step of flattening the resin sealing portion 33 formed in the light guide path 35 so as to be flush with the reflecting member 32 (light introducing window 32w):

With this configuration, a reflecting member 32 having superior reflective properties can be formed easily and highly accurately and fixed with high accuracy, as a result of which the process can be simplified and a highly reliable solar cell 10 having superior heat-resisting properties can be manufactured with good productivity.

As already described in Embodiment 1-1, the reflecting member 32 may be formed with glass instead of a metal. Hereinafter, a method for manufacturing a reflecting member 32 made of glass will be described. This is basically the same as the method for manufacturing a reflecting member 32 made of a metal, and thus mainly the differences will be described here.

The shape of the reflecting member 32 made of glass is the same as that of the reflecting member 32 made of a metal. The reflecting member 32 can be prepared by molding glass and covering the glass with a metal film (a reflecting member preparing step).

First, as with the case of the reflecting member 32 made of a metal, substrate glass is formed by die casting glass or molding glass by hollowing it (a substrate glass forming step as part of the reflecting member preparing step).

Next, in order to impart reflective properties, the surface of the substrate glass is covered with a metal film (a metal film covering step as part of the reflecting member preparing step). As a metal film covering method, a known method such as a vacuum deposition method, a sputtering method or a plating method can be used.

After that, the glass on which a metal film is formed is subjected to a heat treatment to heat the metal film (a metal film heating step as part of the reflecting member preparing step). The heat treatment can be performed, for example, in an oven that has a nitrogen atmosphere (or an air atmosphere can be used) at 450°C for 30 minutes.

After heat treatment, the temperature is slowly decreased from the heat treatment temperature to 200°C at a slow cooling rate of 15°C/min, and then to room temperature, whereby cracking of the glass can be prevented, and the reflecting member 32 can be formed in a stable manner (the reflecting member preparing step).

As described above, because the reflecting member preparing step includes the substrate glass forming step, the metal film covering step and the metal film heating step, a stable metal film can be formed on the glass surface by covering the glass surface with the metal film, as a result of which a highly reliable solar cell manufacturing method can be achieved.

The reflecting member fixing step, the resin sealing step and the surface flattening step are the same as those of the method for manufacturing the reflecting member 32 made of a metal, so a description thereof is omitted here. With this configuration, it is possible to easily and highly accurately form and fix a lightweight reflecting member 32, as a result of which the process can be simplified, and a highly reliable solar cell 10 having superior heat-resisting properties can be manufactured with good productivity.

### Embodiment 1-3

A concentrating photovoltaic power generation unit according to Embodiment 1-3 will be described with reference to FIG. 4. The concentrating photovoltaic power generation unit of the present embodiment is formed by disposing a plurality of concentrating photovoltaic power generation modules 40m that include the solar cells 10 described in Embodiments 1-1 and 1-2.

FIG. 4 is a perspective view schematically showing a configuration of a concentrating photovoltaic power generation unit according to Embodiment 1-3 of the present invention.

A concentrating photovoltaic power generation unit 40 of the present embodiment includes an elongated frame 44 and a plurality of concentrating photovoltaic power generation modules 40m that are arranged along the elongated frame 44. The concentrating photovoltaic power generation modules 40m include the solar cells 10 according to Embodiment 1-1 or 1-2. The concentrating photovoltaic power generation module 40m can also take an independent form by being disposed in a single frame that is different from the elongated frame 44.

With this configuration, because the concentrating photovoltaic power generation unit 40 includes solar cells 10 having superior heat-resisting properties, improved heat-resisting properties and high reliability can be achieved. In addition, concentrated sunlight Ls can be utilized without wasting it, as a result of which a highly efficient and reliable concentrating photovoltaic power generation unit 40 having improved reliability can be obtained.

The concentrating photovoltaic power generation modules 40m include, for example, an approximately 30 cm-square concentrating lens 42, and the concentrating photovoltaic power generation unit 40 can be configured to include, for example, 5x1 (5) concentrating photovoltaic power generation modules 40m. In this case, the concentrating photovoltaic power generation unit 40 forms an approximately 30 cm×150 cm incident face, for example.

In order to generate the electric power needed, an appropriate number of concentrating photovoltaic power generation modules 40m are connected in series or in parallel. In FIG. 4, as an example, a configuration in which seven concentrating photovoltaic power generation units 40 are arranged in parallel to form a concentrating photovoltaic power generation system (concentrating photovoltaic power generation apparatus) is shown.

The concentrating photovoltaic power generation system (concentrating photovoltaic power generation apparatus) configured from a plurality of concentrating photovoltaic power generation units 40 is supported by a support 81, and is configured so as to be automatically driven by a horizontal rotation Roth and a vertical rotation Rotv by a sun-tracking mechanism portion (not shown) so as to track the sun, and to cause the concentrating lens 42 (incident face) disposed on the surface of the concentrating photovoltaic power generation modules 40m to face toward a direction perpendicular to sunlight Ls.

Accordingly, the concentrating photovoltaic power generation unit 40 of the present embodiment is applicable to a concentrating photovoltaic power generation system with a high concentration magnification. In other words, with the concentrating photovoltaic power generation modules 40m of the present invention, it is possible to configure a highly efficient and inexpensive sun-tracking concentrating photovoltaic power generation system having good reliability and weather-resisting properties.

Even if sun-tracking fails due to a sun tracking error or the like, the solar cells 10 will not burn out by the action of the reflecting member 32, and therefore a highly reliable sun-tracking concentrating photovoltaic power generation system can be obtained.

The sun-tracking mechanism portion (sun-tracking driving system) is configured from a sun-tracking driving apparatus having two different axes: an azimuth axis for causing the concentrating lens 42 (incident face) to face toward the orientation of the sun; and an inclining axis for inclining the concentrating lens 42 (incident face) according to the altitude of the sun, and therefore it is possible to track the sun with high accuracy.

As the power system of the sun-tracking driving system, there are methods such as a method of driving the sun-tracking driving system in a predetermined direction by rotating a gear a predetermined number of times using a motor and a decelerator, and a method of driving the sun-tracking driving system in a predetermined direction by adjusting a cylinder to a predetermined length using a hydraulic pump and a hydraulic cylinder. Either method can be used.

As the sunlight-tracking method, the following methods are known: a method in which the orbit of the sun is calculated in advance by a clock that controls the operation of the sun-tracking driving system, which is included inside the sun-tracking driving system, and control is exerted so as to move the concentrating photovoltaic power generation modules 40m (concentrating photovoltaic power generation units 40) to face the orientation of the sun; and a method in which a solar sensor made of a photodiode or the like is attached to the sun-tracking driving system, and control is exerted so as to monitor the direction of the sun at any appropriate time; and either method can be used.

### Embodiment 2-1

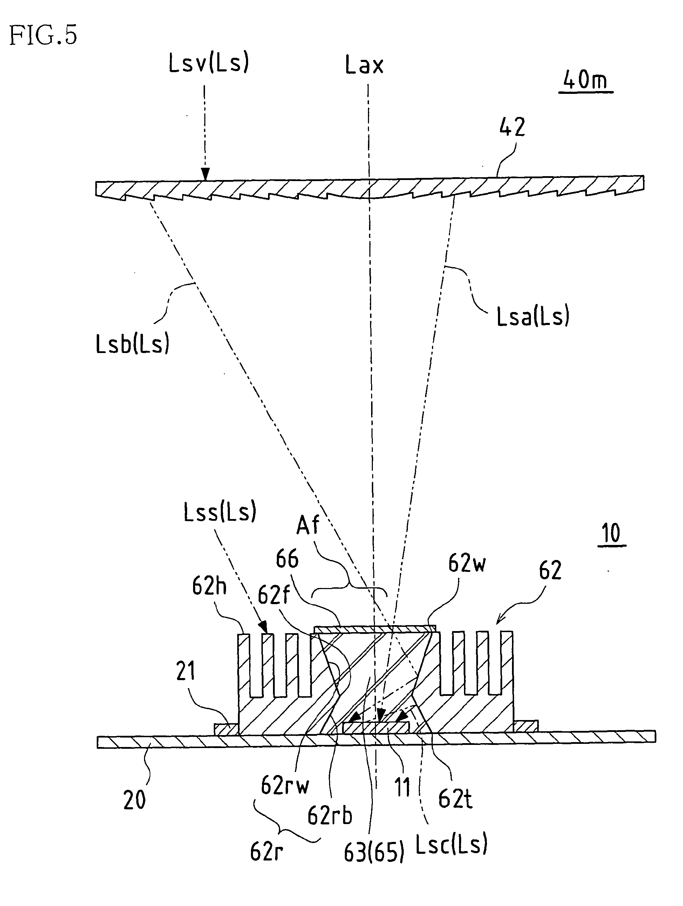

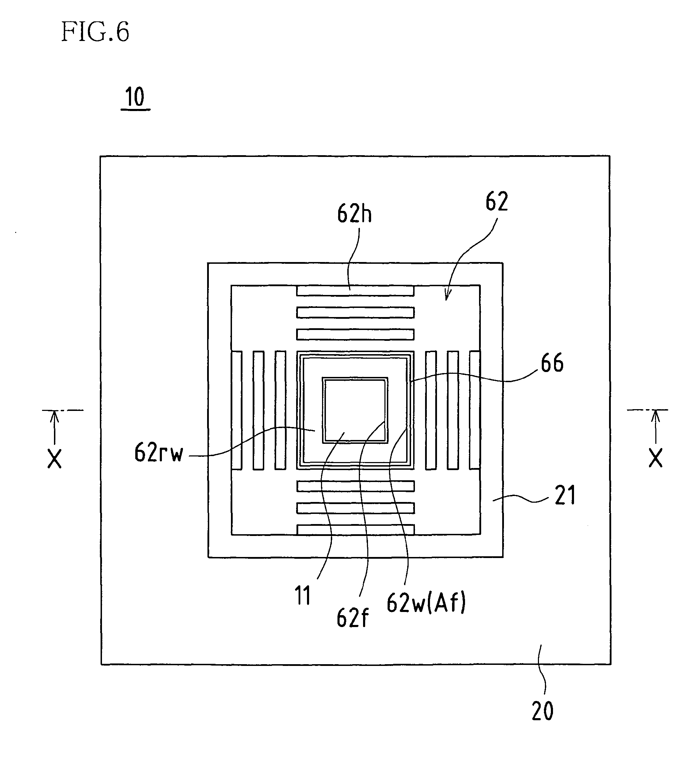

A solar cell and a concentrating photovoltaic power generation module according to the present embodiment will be described with reference to FIGS. 5 and 6.

FIG. 5 is a cross-sectional view showing a configuration of a solar cell and a concentrating photovoltaic power generation module according to Embodiment 2-1 of the present invention. FIG. 6 is a plan view showing a state of the solar cell shown in FIG. 5 as viewed from the concentrating lens side.

A solar cell 10 of the present embodiment includes a solar cell element 11 for converting sunlight Lsa that has been concentrated by a concentrating lens 42 that is disposed perpendicularly to the optical axis Lax into electricity, a receiver substrate 20 on which the solar cell element 11 is placed, and a resin sealing portion 63 that resin-seals the solar cell element 11.

The solar cell 10 includes a reflecting member 62 that is disposed in contact with the receiver substrate 20 in the periphery of the solar cell element 11. The reflecting member 62 has: a light guide path 65 that guides, to the solar cell element 11, sunlight Ls generated by concentrating sunlight Lsv (sunlight Ls) that has entered perpendicularly to the concentrating lens 42 (in the direction parallel to the optical axis Lax) by the concentrating lens 42 (sunlight Lsa that is directed directly to the solar cell element 11 by being concentrated by the concentrating lens 42, and sunlight Lsb that has been concentrated by the concentrating lens 42 but has deviated so that it is introduced in a direction oblique to the light guide path 65, reflected by a reflecting face 62r and directed to the solar cell element 11, hereinafter the sunlight Lsv, the sunlight Lsa and the sunlight Lsb are referred to simply as sunlight Ls, where it is unnecessary to distinguish them); and the reflecting face 62r that defines the guide path 65 and reflects sunlight Ls toward the solar cell element 11. The resin sealing portion 63 is formed by resin-sealing the light guide path 65.

In the solar cell 10 of the present embodiment, the light guide path 65 defined by the reflecting member 62, which serves as the resin sealing portion 63, can be positioned with respect to the solar cell element 11 with high accuracy. In addition, the reflecting member 62 is provided that directs concentrated sunlight Ls (sunlight Lsa and sunlight Lsb) to the solar cell element 11 without wasting it, that reflects sunlight Ls (sunlight Lsc, hereinafter also referred to simply as sunlight Ls, where it is unnecessary to distinguish it from sunlight Lsa and sunlight Lsb) that has not been absorbed by the solar cell element 11 and therefore has been reflected from the solar cell element 11 again toward the solar cell element 11 so as to be absorbed by the solar cell element 11, that improves heat dissipation from the front side (the solar cell element 11 side) of the receiver substrate 20, and that reflects sunlight Ls (sunlight Lss, also referred to simply as sunlight Ls, where it is unnecessary to distinguish it from sunlight Lsa, sunlight Lsb and sunlight Lsc) that has deviated with respect to the light guide path 65, whereby the output properties of the solar cell element 11 can be improved the power generation efficiency can be improved, and the heat-resisting properties, reliability and weather-resisting properties can be improved.

The light guide path 65 includes an irradiation window 62f through which sunlight Ls (sunlight Lsa and sunlight Lsb) guided to the light guide path 65 is directed to the solar cell element 11, a light introducing window 62w that is formed larger than the irradiation window 62f and through which sunlight Ls is introduced, and a contact window 62t that is formed larger than the irradiation window 62f and is brought into contact with the receiver substrate 20 in the periphery of the solar cell element 11.

The reflecting face 62r includes a light introducing-side reflecting face 62rw that is formed between the irradiation window 62f and the light introducing window 62w and that reflects and guides sunlight Lsb toward the solar cell element 11, and a substrate-side reflecting face 62rb that is formed between the irradiation window 62f and the contact window 62t and that reflects sunlight Ls (sunlight Lsc that has not been absorbed by the solar cell element 11 and therefore has been reflected from the solar cell element 11) toward the solar cell element 11.

Accordingly, sunlight Ls (sunlight Lsa and sunlight Lsb) that has entered the light introducing window 62w from the outside can be efficiently concentrated onto the irradiation window 62f by the light introducing-side reflecting face 62rw with high accuracy and directed to the solar cell element 11, while sunlight Ls (sunlight Lsc) that has not been absorbed by the solar cell element 11 and therefore has been reflected can be reflected again by the substrate-side reflecting face 62rb and directed to the solar cell element 11, as a result of which the sunlight Ls can be utilized without wasting it, and the power generation and the power generation efficiency can be further improved.

The solar cell element 11 is made of an inorganic material such as, for example, Si, GaAs, CuInGaSe or CdTe. As the structure of the solar cell element 11, a variety of types of structures can be used such as a single-junction type solar cell, a monolithic multijunction type solar cell, and a mechanical stack type in which various solar cells having different wavelength sensitivity ranges are connected.

It is desirable that the external size of the solar cell element 11 is from approximately several millimeters to approximately 20 mm from the viewpoint of a reduction in the solar cell material used, processing cost, ease of processing, simplification, and so on.

In addition, in order to reduce the light reflection coefficient in the wavelength sensitivity range of the solar cell element 11, a suitable anti-reflection film or the like may be provided on the surface of the solar cell element 11. Furthermore, a UV reflective film, an infrared reflective film or the like that reflects light of wavelengths other than the wavelength sensitivity range of the solar cell element 11 may be provided.

In the receiver substrate 20, desired wiring (a connection pattern that is connected to the electrodes (not shown) of the solar cell element 11 and that performs output to the outside, or a connection pattern for connecting solar cells 10 in series or in parallel, not shown) is formed on a base (not shown) such as an aluminum plate or copper plate with an appropriate insulating layer interposed therebetween.

In other words, a configuration is adopted in which the current generated by the solar cell element 11 is output to the outside of the solar cell 10 with the wiring formed in the receiver substrate 20 as appropriate. Because the wiring formed in the receiver substrate 20 is required to secure highly reliable insulation capabilities, a configuration, for example, is adopted in which insulation is provided by covering the connection pattern formed of a copper foil with an insulating film (organic member) made of an organic material or the like.

As described above, the receiver substrate 20 has a metal base, and the reflecting member 62 is in contact with the base. Accordingly, the thermal resistance between the solar cell element 11 and the reflecting member 62 can be reduced, and therefore the heat generated in the solar cell element 11 and the receiver substrate 20 can be efficiently dissipated to the outside via the base and the reflecting member 62.

Also, the reflecting member 62 is bonded to the receiver substrate 20 over a certain amount of area by a bonding portion 21. Accordingly, the heat generated in the receiver substrate 20 can be efficiently conducted to the reflecting member 62 made of a metal. It is also possible to dispose the bonding portion 21 between the receiver substrate 20 (base) and the reflecting member 62.

The reflecting member 62 includes a comb-like fin 62h in the peripheral region of the light guide path 65 on the side opposite to the side in contact with the receiver substrate 20. Accordingly, the heat dissipation properties of the reflecting member 62 can be improved and heat can be efficiently dissipated, as a result of which the power generation efficiency of the solar cell 10 can be improved and a reduction in the power generation can be prevented.

The reflecting member 62 is formed of a metal as in the base of the receiver substrate 20. Accordingly, it is possible to easily and highly accurately form the reflecting member 62 whose the reflecting face 62r (the light introducing-side reflecting face 62rw and the substrate-side reflecting face 62rb) is highly reflective, and that can effectively reflect sunlight Ls and has high heat dissipation properties, and therefore the reflecting member 62 can be formed inexpensively with good mass productivity.

Because the reflecting member 62 is disposed in the periphery (in other words, the periphery of the irradiation window 62f) of the solar cell element 11 (or the light concentration region Af corresponding to the effective light-receiving face region) such that sunlight Ls (sunlight Lss) deviated with respect to the light guide path 65 is reflected, even if sunlight Lss is generated, the sunlight Lss is reflected, whereby excessive irradiation of the receiver substrate 20 with the sunlight Lss can be prevented, and the temperature increase that causes decreased efficiency in the solar cell element 11 can be suppressed (reduced).

In other words, irradiation of the receiver substrate 20 with the sunlight Lss that does not contribute to the photoelectric conversion of the solar cell element 11 is prevented, and the temperature increase of the receiver substrate 20 is avoided, as a result of which burnout of the members disposed on the receiver substrate 20 and the like can be prevented, improving the heat-resisting properties of the solar cell 10 and preventing lowering of the power generation amount.

In addition, by forming the base of the receiver substrate 20 and the reflecting member 62 with a metal, the receiver substrate 20 (base) and the reflecting member 62 can be bonded easily.

In addition, the resin sealing portion 63 is made of an insulating resin that covers the solar cell element 11 and is charged into the light guide path 65. For example, the resin sealing portion 63 is formed by using a transparent silicone resin such that sunlight Ls concentrated onto the light introducing window 62w is directed to the solar cell element 11.

The thickness of the resin sealing portion 63 located directly above the solar cell element 11 is greater than or equal to the thickness of the reflecting member 62. Accordingly, it is possible to prevent extraneous matter from being attached to the solar cell element 11, and the surface of the resin sealing portion 63 can be made an off-focus position, and therefore the intensity of sunlight Ls on the surface of the resin sealing portion 63 can be suppressed, thereby suppressing the temperature increase on the surface of the resin sealing portion 63, and when extraneous matter is attached to the surface of the resin sealing portion 63, damage and breakage to the solar cell element 11 are prevented, as a result of which a highly safe and reliable solar cell 10 can be obtained.

The surface of the resin sealing portion 63 facing the concentrating lens 42 is formed as a flat face. Accordingly, sunlight Ls can be guided to the resin sealing portion 63 with high accuracy, and therefore the incident accuracy of the sunlight Ls directed to the solar cell element 11 can be improved and stabilized, and the power generation efficiency can be stabilized.

The surface of the resin sealing portion 63 facing the concentrating lens 42 is covered with a cover member 66. Accordingly, water can be prevented from intruding into the resin sealing portion 63, and therefore a highly reliable solar cell 10 that can protect the solar cell element 11 from water intrusion can be obtained.

The cover member 66 is made of, for example, a glass plate, and secures the heat-resisting properties and moisture-resisting properties of the solar cell 10, thereby improving the weather-resisting properties. The thickness of the reflecting member 62 is set such that the irradiation intensity of sunlight Ls on the surface thereof facing the concentrating lens 42 is suppressed to, for example, approximately 0.35 kW/m² and that heat-resisting properties can be secured.

A concentrating photovoltaic power generation module 40m according to the present embodiment includes a concentrating lens 42 that concentrates and directs received sunlight Lsv to a solar cell 10, and the solar cell 10 that converts sunlight Ls (sunlight Lsa and sunlight Lsb) concentrated by the concentrating lens 42 into electricity.

Accordingly, because a highly efficient solar cell 10 having superior heat-resisting properties is included, sunlight Ls concentrated by the concentrating lens 42 can be efficiently used by the solar cell 10, and heat dissipation properties can be improved, as a result of which a concentrating photovoltaic power generation module 40m that has improved power generation efficiency, heat-resisting properties, reliability and weather-resisting properties can be obtained.

For a solar cell element 11 used in the concentrating photovoltaic power generation module 40m, because it is required to have high efficiency and practical usefulness in particular, it is desirable to use an InGaP/GaAs/Ge triple-junction solar cell element, an AlGaAs/Si solar cell element, or a monolithic multijunction solar cell element.

In order to provide efficient light concentration of the concentrating lens 42, the surface of the solar cell element 11 for converting sunlight Ls into electricity is made flat and disposed in parallel with the incident face of the concentrating lens 42 and the incident face and emitting face of the cover member 66.

The concentrating lens 42 is configured so as to face the sun by the action of a sun-tracking mechanism (not shown). Accordingly, sunlight Lsv enters perpendicularly to the incident face of the concentrating lens 42 (in the direction parallel to the optical axis Lax). Also, the concentrating lens 42 is configured to refract received sunlight Lsv so as to concentrate sunlight Lsa on the solar cell element 11.

Most of the sunlight Lsv is concentrated onto the solar cell element 11 as sunlight Lsa, but the sunlight Ls in a certain wavelength range (short wavelength range in particular) that has entered the groove edge portion of the concentrating lens 42 cannot be concentrated directly to the solar cell element 11. In other words, the sunlight Ls in a specific wavelength range that has entered the groove edge portion of the concentrating lens 42 is not concentrated directly to the solar cell element 11, and instead is directed to the light introducing-side reflecting face 62rw via the light introducing window 62w, reflected by the light introducing-side reflecting face 62rw and indirectly concentrated onto the solar cell element 11.

According to conventional technology, which does not include such a reflecting member 62, deviated sunlight Lsb is not concentrated onto the solar cell element 11 and therefore lost, whereas according to the present embodiment, the light introducing window 62w serves as a light concentration region Af that guides sunlight Ls (sunlight Lsa and sunlight Lsb) refracted by the concentrating lens 42 to the solar cell element 11, and therefore deviated sunlight Lsb is regarded as a target to be concentrated and concentrated onto the solar cell element 11. Accordingly, sunlight Ls can be concentrated more effectively as compared to the conventional technology.

The light introducing window 62w is formed to have a size that allows short-wavelength light that has been refracted at the end portion of the concentrating lens 42 and enters the solar cell element 11 to pass therethrough (to be introduced thereinto). The light introducing-side reflecting face 62rw has the same degree of incline as that of a straight line connecting a tip end portion of the solar cell element 11 and an end portion of the concentrating lens 42 corresponding to the tip end portion of the solar cell element 11.

Accordingly, because the sunlight Lsa refracted by the concentrating lens 42 enters directly the solar cell element 11, and the sunlight Lsb that is not concentrated directly to the solar cell element 11 by refraction of the concentrating lens 42 is concentrated onto the light introducing window 62w (the light concentration region Af) and then reflected toward the solar cell element 11 by the light introducing-side reflecting face 62rw, the power generation and power generation efficiency of the solar cell 10 can be improved.

In addition, in the reflecting member 62 (light guide path 65), the irradiation window 62f formed to have a similar shape as that of the solar cell element 11 (effective light-receiving face region) is formed in a region corresponding to concentrated sunlight Lsa, so that the concentrated sunlight Lsa is directed directly to the solar cell element 11. Accordingly, a configuration is adopted in which in a state in which the concentrating lens 42 is in the normal position, sunlight Lsa is reliably concentrated onto the solar cell element 11.

When the position of the concentrating lens 42 is shifted, concentrated sunlight Ls (sunlight Lsa) is brought into the state of sunlight Lsb, but as described above, sunlight Lsb is reflected by the light introducing-side reflecting face 62rw toward the solar cell element 11, and therefore the loss caused by positional shift of the concentrating lens 42 can be suppressed.

In addition, the sunlight Lsb that has entered the solar cell element 11 by being reflected by the light introducing-side reflecting face 62rw has a shallow angle of incidence with respect to the solar cell element 11 due to the incline of the light introducing-side reflecting face 62rw, and therefore a situation can occur in which part of the sunlight Lsb is reflected from the solar cell element 11 as sunlight Lsc.

However, the substrate-side reflecting face 62rb has the same degree of incline as that of a straight line connecting the irradiation window 62f and the contact window 62t corresponding to the irradiation window 62f, and the contact window 62t is formed larger than the solar cell element 11 (effective light-receiving face region). Accordingly, the substrate-side reflecting face 62rb can cause the sunlight Lsc that has been reflected from the surface of the solar cell element 11 to reenter the solar cell element 11, and therefore the power generation and power generation efficiency of the solar cell 10 can be improved.

As described above, because the reflecting member 62 can be provided only by providing the resin sealing portion 63 constituting the light guide path 65 directly on the solar cell element 11, and no other members are necessary, it can be formed inexpensively. Also, the sunlight Lsb, which was a loss in conventional technology, can be made to enter the solar cell element 11 by the reflecting member 62 (light introducing-side reflecting face 62rw), so that the efficiency of the solar cell element 11 can be improved. Furthermore, the sunlight Lsc reflected at the surface of the solar cell element 11 can be caused to reenter the solar cell element 11 by the reflecting member 62 (substrate-side reflecting face 62rb), and therefore the power generation and power generation efficiency of the solar cell element 11 can be further improved.

The sunlight Lsv that is allowed to enter perpendicularly to the concentrating lens 42 by the sun-tracking mechanism is concentrated by the concentrating lens 42 as sunlight Lsa, and then directed to the solar cell element 11. However, as described above, a situation can occur in which the sunlight deviates due to, for example, the occurrence of a sun tracking error or alignment error in the optical system, and the light concentration spot is shifted to the outside of the light concentration region Af.

In other words, a situation can occur in which deviated sunlight Lss is directed to the solar cell 10. Hereinafter, positional shifting of the light concentration spot due to a sun tracking error, alignment error, variation of light intensity or the like will also be referred to simply as shifting due to a sun tracking error (sun tracking error, etc).

In the present embodiment, the reflecting member 62 is disposed at the outside of the light concentration region Af. Accordingly, even if concentrated sunlight Ls deviates due to, for example, a sun tracking error or the like, and becomes sunlight Lss that is directed to a position different from the position (effective light-receiving face region) of the solar cell element 11, irradiation of the receiver substrate 20 with the sunlight Lss can be prevented by the reflecting member 62.

In other words, because irradiation of the receiver substrate 20 with the sunlight Lss can be prevented by disposing the reflecting member 62 on the receiver substrate 20 in the periphery of the solar cell element 11, the increase of the surface temperature of the receiver substrate 20 can be suppressed, and burnout of the members disposed on the surface of the receiver substrate 20 can be prevented.

Because the wiring formed on the surface of the receiver substrate 20 is made of an organic member having low heat-resisting properties as described above, if irradiated with sunlight Lss, the organic member may be damaged, leading to damage to the wiring, and the reliability of the solar cell 10 may be reduced. However, because the reflecting member 62 is provided, it is possible to prevent sunlight Lss from being directly directed to the receiver substrate 20 (wiring) and avoid damage to the wiring, and the like.

Accordingly, by disposing the reflecting member 62, even in the case of a high concentration magnification such as 600 SUN (1 SUN = 100 mW/cm²) or more, it is possible to prevent the wiring (organic member) and the like of the receiver substrate 20 from being burnt, as a result of which a highly efficient and inexpensive solar cell 10 having improved heat-resisting properties, good reliability and weather-resisting properties can be obtained.

The concentrating lens 42 that can be applied to the concentrating photovoltaic power generation module 40m can be a biconvex lens, a planoconvex lens, a Fresnel lens or the like. From the viewpoint of weight, cost, ease of handling in the use environment and the like, it is desirable that the incident face that receives sunlight Ls is flat, and that the emitting face from which the sunlight Ls is directed to the solar cell element 11 has the shape of a Fresnel lens having a substantially triangular cross section. The concentrating lens 42 can also be configured by arranging a plurality of the same optical systems in an array to form a single body (see FIG. 4).

It is preferable that the material for the concentrating lens 42 has a high transmittance at the sensitivity wavelength light of the solar cell element 11 and weather-resisting properties. For example, it is possible to use a thin plate glass, weather-resisting properties grade acrylic resin, polycarbonate or the like generally used in conventional concentrating photovoltaic power generation modules (photovoltaic power generation systems) or the like. The material for the concentrating lens 42 is not limited to those listed above, and it can be formed from a plurality of layers of such materials. Also, a suitable ultraviolet-absorbing agent can be added to such materials for the purpose of preventing ultraviolet deterioration of the concentrating lens 42 itself and other members.

### Embodiment 2-2

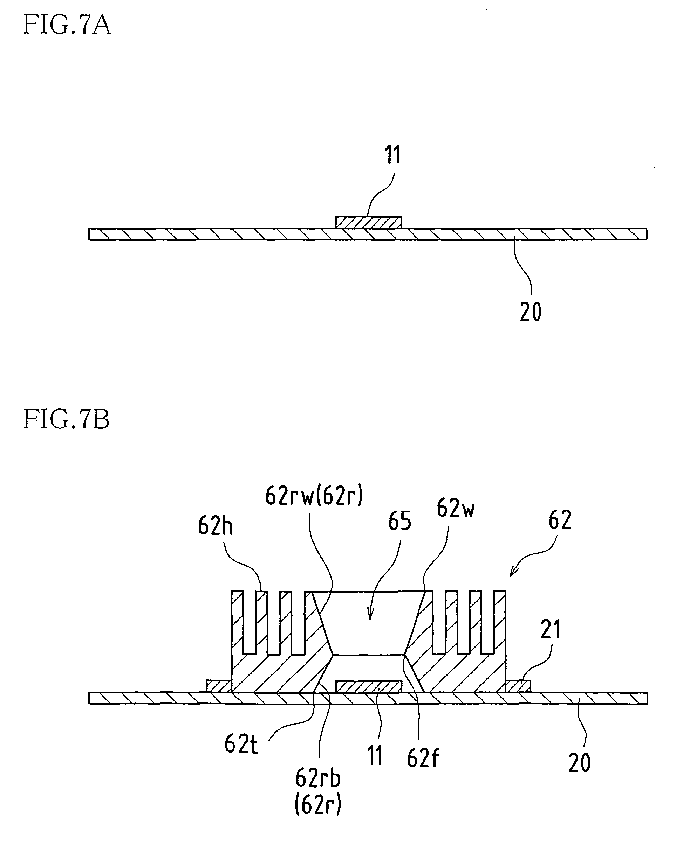

A solar cell manufacturing method according to the present embodiment will be described with reference to FIGS. 7A to 7D. A solar cell manufactured by the solar cell manufacturing method of the present embodiment is the solar cell 10 according to Embodiment 2-1, so the reference numerals used in Embodiment 2-1 are used here as well.

Apart from the step of FIG. 7A (a solar cell element mounting step), a reflecting member 62 is first prepared by molding a metal (a reflecting member preparing step, not shown). The shape of the reflecting member 62 is the same as that described in Embodiment 2-1, so a description thereof is omitted here.

That is, a reflecting member 62 that includes a light guide path 65 and a fin 62h is formed and prepared. Specifically, a reflecting face 62r (a light introducing-side reflecting face 62rw and a substrate-side reflecting face 62rb) that forms a light guide path 65 that is made up of a light introducing window 62w, an irradiation window 62f and a contact window 62t is formed in a metal block (metal plate). At the same time, a fin 62h is formed in the peripheral region of the light guide path 65.

The incline of the reflecting face 62r is set such that sunlight Ls (sunlight Lsb and sunlight Lsc) can be caused to effectively enter the solar cell element 11. As the reflecting member 62 manufacturing method, a die casting method or a method in which a metal plate is hollowed can be used.

In order to improve the reflection coefficient of the reflecting face 62r, it is desirable that the reflecting face 62r is, for example, mirror-finished. It is also possible to form a metal film on the reflecting face 62r. As the film forming method, for example, a vacuum deposition method, a sputtering method, a plating method or the like can be used.

FIG. 7A is a process diagram illustrating a solar cell manufacturing method according to Embodiment 2-2 of the present invention, and shows a state in which a solar cell element is placed on a receiver substrate in cross section taken along the line X-X of FIG. 6.

Apart from the reflecting member preparing step, a solar cell element 11 is mounted onto a receiver substrate 20 (a solar cell element mounting step).

FIG. 7B is a process diagram illustrating the solar cell manufacturing method according to Embodiment 2-2 of the present invention, and shows a state in which a reflecting member is placed on the receiver substrate in cross section taken along the line X-X of FIG. 6.

After mounting the solar cell element 11 on the receiver substrate 20, a bonding portion 21 is formed on the receiver substrate 20 so as to correspond to a position in which the reflecting member 62 is disposed in the periphery of the solar cell element 11 (a bonding portion forming step). The bonding portion 21 can be formed by, for example, forming and disposing a metal frame or plastic frame, but it is desirable to dispose a resin or adhesive that can bond the reflecting member 62 as appropriate.

The bonding portion 21 is disposed so as to bond the reflecting member 62 to the receiver substrate 20 at the side face of the reflecting member so that the reflecting member 62 can be brought into direct contact with the base (not shown) of the receiver substrate 20. In the case of using an adhesive with high heat conducting properties, the bonding portion 21 may be interposed between the receiver substrate 20 and the reflecting member 62.

After forming the bonding portion 21, the reflecting member 62 is positioned with the bonding portion 21 and disposed so as to be in contact with the receiver substrate 20 (a reflecting member disposing step). At this time, the reflecting member 62 is placed such that the center of the light introducing window 62w (irradiation window 62f) and the center of the solar cell element 11 (effective light-receiving face region) match.

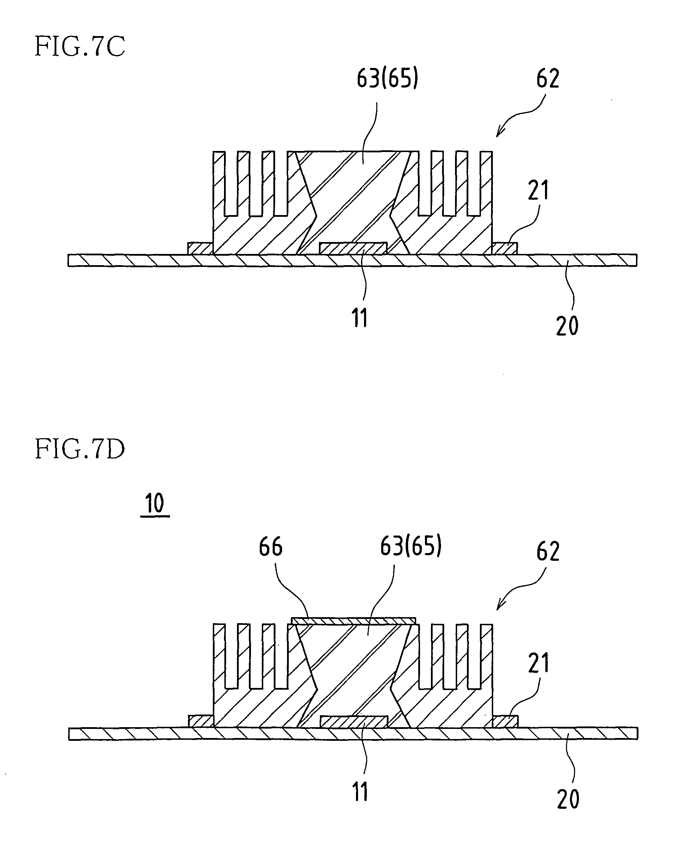

FIG. 7C is a process diagram illustrating the solar cell manufacturing method according to Embodiment 2-2 of the present invention, and shows a state in which a resin sealing portion is formed in a light guide path of the reflecting member in cross section taken along the line X-X of FIG. 6.

A sealing resin is charged into a light guide path 65 so as to form a resin sealing portion 63 (a resin sealing step). In other words, the solar cell element 11 mounted on the receiver substrate 20 is covered with the sealing resin, and the light guide path 65 extending from the light introducing window 62w to the solar cell element 11 is filled with the sealing resin for protection.

FIG. 7D is a process diagram illustrating the solar cell manufacturing method according to Embodiment 2-2 of the present invention, and shows a state in which the resin sealing portion is covered with a cover member in cross section taken along the line X-X of FIG. 6.

After forming the resin sealing portion 63, the surface of the resin that has been charged so as to obtain stable output properties is processed to form a flat face (a flat face forming step), and a cover member 66 that further protects the solar cell element 11 from moisture and water is placed.

As described above, the solar cell manufacturing method according to the present embodiment relates to a solar cell manufacturing method for manufacturing a solar cell 10 that includes a solar cell element 11 for converting sunlight Ls concentrated by the concentrating lens 42 into electricity, a receiver substrate 20 on which the solar cell element 11 is placed, a resin sealing portion 63 that resin-seals the solar cell element 11, and a reflecting member 62 that is disposed in contact with the receiver substrate 20 in the periphery of the solar cell element 11, and that has a light guide path 65 that guides sunlight Ls to the solar cell element 11 and a reflecting face 62r that defines the light guide path 65 and that reflects the sunlight Ls toward the solar cell element 11.

The solar cell manufacturing method according to the present embodiment involves a reflecting member preparing step of preparing the reflecting member 62 by molding a metal, a reflecting member disposing step of disposing the reflecting member 62 so as to be in contact with the receiver substrate 20 in the periphery of the solar cell element 11, a resin sealing step of forming the resin sealing portion 63 by charging a sealing resin in the light guide path 65, and a flat face forming step of forming a flat face by processing the surface of the resin sealing portion 63.

Accordingly, because the reflecting member 62 that has the light guide path 65 and the reflecting face 62r can be disposed in contact with the receiver substrate 20 with high accuracy and the resin sealing portion 63 can be formed with high accuracy, a solar cell 10 having improved heat-resisting properties, reliability and weather-resisting properties that can utilize sunlight Ls concentrated by the concentrating lens 42 without wasting it and improves heat dissipation properties, thereby improving power generation efficiency can be manufactured with good productivity.

### Embodiment 2-3

A concentrating photovoltaic power generation unit according to the present embodiment will be described with reference to FIG. 4. The concentrating photovoltaic power generation unit of the present embodiment is formed by disposing a plurality of concentrating photovoltaic power generation modules 40m that include the solar cells 10 described in Embodiments 2-1 and 2-2, so the same reference numerals as those of Embodiments 2-1 and 2-2 are used here.

FIG. 4 is a perspective view schematically showing a configuration of a concentrating photovoltaic power generation unit according to Embodiment 2-3 of the present invention.

A concentrating photovoltaic power generation unit 40 of the present embodiment includes an elongated frame 44 and a plurality of concentrating photovoltaic power generation modules 40m that are arranged along the elongated frame 44. The concentrating photovoltaic power generation module 40m can also take an independent form by being disposed in a single frame that is different from the elongated frame 44.

Accordingly, the sunlight Ls concentrated by the concentrating lenses 42 can be utilized without wasting it by the concentrating photovoltaic power generation modules 40m, and heat dissipation properties can be improved, as a result of which it is possible to obtain a concentrating photovoltaic power generation unit 40 having improved power generation efficiency, heat-resisting properties, reliability and weather-resisting properties.

The concentrating photovoltaic power generation modules 40m include, for example, an approximately 30 cm-square concentrating lens 42, and the concentrating photovoltaic power generation unit 40 can be configured to include, for example, 5×1 (5) concentrating photovoltaic power generation modules 40m. In this case, the concentrating photovoltaic power generation unit 40 forms an approximately 30 cm×150 cm light-receiving face, for example.

In order to generate the electric power needed, an appropriate number of concentrating photovoltaic power generation modules 40m are connected in series or in parallel. In the present embodiment, as an example, a configuration in which seven concentrating photovoltaic power generation units 40 are arranged in parallel to form a concentrating photovoltaic power generation system (concentrating photovoltaic power generation apparatus) is shown.

The concentrating photovoltaic power generation system (concentrating photovoltaic power generation apparatus) configured from a plurality of concentrating photovoltaic power generation units 40 is supported by a support 81, and is configured so as to be automatically driven by a horizontal rotation Roth and a vertical rotation Rotv by a sun-tracking mechanism portion (not shown) so as to track the sun, and to cause the concentrating lens 42 (incident face) disposed on the surface of the concentrating photovoltaic power generation modules 40m to face toward a direction perpendicular to sunlight Lsv.

Accordingly, the concentrating photovoltaic power generation unit 40 of the present embodiment is applicable to a concentrating photovoltaic power generation system with a high concentration magnification. In other words, with the concentrating photovoltaic power generation modules 40m of the present invention, it is possible to configure a highly efficient and inexpensive sun-tracking concentrating photovoltaic power generation system having good reliability and weather-resisting properties.

Even if sun-tracking fails due to a sun tracking error or the like, the solar cells 10 will not burn out, and therefore a highly reliable sun-tracking concentrating photovoltaic power generation system can be obtained.

The sun-tracking mechanism portion (sun-tracking driving system) is configured from a sun-tracking driving apparatus having two different axes: an azimuth axis for causing the concentrating lens 42 (incident face) to face toward the orientation of the sun; and an inclining axis for inclining the concentrating lens 42 (incident face) according to the altitude of the sun, and therefore it is possible to track the sun with high accuracy.

As the power system of the sun-tracking driving system, there are methods such as a method of driving the sun-tracking driving system in a predetermined direction by rotating a gear a predetermined number of times using a motor and a decelerator, and a method of driving the sun-tracking driving system in a predetermined direction by adjusting a cylinder to a predetermined length using a hydraulic pump and a hydraulic cylinder. Either method can be used.

As the sunlight sun-tracking method, the following methods are known: a method in which the orbit of the sun is calculated in advance by a clock that controls the operation of the sun-tracking driving system, which is included inside the sun-tracking driving system, and control is exerted so as to move the concentrating photovoltaic power generation modules 40m (concentrating photovoltaic power generation units 40) to face the orientation of the sun; and a method in which a solar sensor made of a photodiode or the like is attached to the sun-tracking driving system, and control is exerted so as to monitor the direction of the sun at any appropriate time; and either method can be used.

The present invention may be embodied in various other forms without departing from the gist or essential characteristics thereof. Therefore, the embodiments disclosed in this application are to be considered in all respects as illustrative and not limiting. The scope of the invention is indicated by the appended claims rather than by the foregoing description, and all modifications or changes that come within the meaning and range of equivalency of the claims are intended to be embraced therein.

This application claims priority on Japanese Patent Application No. 2007-249551 filed in Japan on September 26, 2007 and Japanese Patent Application No. 2008-016592 filed on January 28, 2008, the entire content of which is incorporated herein by reference. Furthermore, the entire contents of references cited in the present specification are herein specifically incorporated by reference.

### Industrial Applicability

The present invention is applicable to a high power output solar cell, concentrating photovoltaic power generation module, concentrating photovoltaic power generation unit and solar cell manufacturing method wherein the heat-resisting properties, light concentrating efficiency, reliability and weather-resisting properties are improved, and is useful.

## Claims

1. A solar cell comprising a solar cell element that converts sunlight concentrated by a concentrating lens into electricity, a receiver substrate on which the solar cell element is placed, and a resin sealing portion that resin-seals the solar cell element,
wherein the solar cell comprises a plate-like reflecting member that is disposed facing the solar cell element and the receiver substrate and that has an irradiation window through which sunlight is directed to the solar cell element, a light introducing window that is formed larger than the irradiation window and through which sunlight is introduced, and a reflecting face that is formed between the irradiation window and the light introducing window and that reflects and guides sunlight to the solar cell element, and
the reflecting member is brought into contact with the resin sealing portion.

2. The solar cell according to claim 1,
wherein the irradiation window and the reflecting face are resin-sealed by the resin sealing portion.

3. The solar cell according to claim 2,
wherein the light introducing window and the resin sealing portion are flush with each other.

4. The solar cell according to claim 1,
wherein the light introducing window is covered with a cover member.

5. The solar cell according to claim 1,
wherein the reflecting member is fixed to the receiver substrate via a reflecting member fixing means.

6. The solar cell according to claim 5,
wherein the reflecting member fixing means is a sealing frame portion that serves as a resin stopper when the resin sealing portion is formed by resin-sealing.

7. The solar cell according to claim 1,
wherein the reflecting member is made of a metal.

8. The solar cell according to claim 7,
wherein the reflecting face is mirror-finished.

9. The solar cell according to claim 1,
wherein the reflecting member is formed by covering glass with a metal film.

10. A concentrating photovoltaic power generation module comprising a concentrating lens that concentrates sunlight and a solar cell that converts sunlight concentrated by the concentrating lens into electricity,
wherein the solar cell is the solar cell according to any one of claims 1 to 9.

11. A concentrating photovoltaic power generation unit comprising an elongated frame and a plurality of concentrating photovoltaic power generation modules that are arranged along the elongated frame,
wherein the concentrating photovoltaic power generation modules are the concentrating photovoltaic power generation modules according to claim 10.

12. A solar cell manufacturing method for manufacturing a solar cell comprising a solar cell element that converts sunlight concentrated by a concentrating lens into electricity, a receiver substrate on which the solar cell element is placed, a resin sealing portion that resin-seals the solar cell element, and a plate-like reflecting member that is disposed facing the solar cell element and the receiver substrate and that has a reflecting face for reflecting and guiding sunlight to the solar cell element, the method comprising:
a reflecting member preparing step of preparing the reflecting member by molding a metal;
a reflecting member fixing step of fixing the reflecting member so as to face the solar cell element and the receiver substrate;
a resin sealing step of forming the resin sealing portion by charging a sealing resin between the receiver substrate and the reflecting member via a light guide path formed by the reflecting face; and
a surface flattening step of flattening the resin sealing portion formed in the light guide path so as to be flush with the reflecting member.

13. A solar cell manufacturing method for manufacturing a solar cell comprising a solar cell element that converts sunlight concentrated by a concentrating lens into electricity, a receiver substrate on which the solar cell element is placed, a resin sealing portion that resin-seals the solar cell element, and a plate-like reflecting member that is disposed facing the solar cell element and the receiver substrate and that has a reflecting face for reflecting and guiding sunlight to the solar cell element, the method comprising:
a reflecting member preparing step of preparing the reflecting member by molding glass and covering the glass with a metal film;
a reflecting member fixing step of fixing the reflecting member so as to face the receiver substrate and the solar cell element;
a resin sealing step of forming the resin sealing portion by charging a sealing resin between the receiver substrate and the reflecting member via a light guide path formed by the reflecting face; and
a surface flattening step of flattening the resin sealing portion formed in the light guide path so as to be flush with the reflecting member.

14. The solar cell manufacturing method according to claim 13,
wherein the reflecting member preparing step comprises:
a substrate glass forming step of forming substrate glass by molding glass;
a metal film covering step of covering a surface of the substrate glass with a metal film; and
a metal film heating step of heating the metal film.

15. A solar cell comprising a solar cell element that converts sunlight concentrated by a concentrating lens into electricity, a receiver substrate on which the solar cell element is placed, and a resin sealing portion that resin-seals the solar cell element,
wherein the solar cell comprises a reflecting member that is disposed in contact with the receiver substrate in a periphery of the solar cell element and that has a light guide path that guides sunlight to the solar cell element and a reflecting face that defines the light guide path and that reflects sunlight to the solar cell element, and
the resin sealing portion is formed by resin-sealing the light guide path.

16. The solar cell according to claim 15,
wherein the light guide path includes an irradiation window through which sunlight is directed to the solar cell element, a light introducing window that is formed larger than the irradiation window and through which sunlight is introduced, and a contact window that is formed larger than the irradiation window and that is in contact with the receiver substrate in a periphery of the solar cell element, and
the reflecting face includes a light introducing-side reflecting face that is formed between the irradiation window and the light introducing window and that reflects and guides sunlight to the solar cell element and a substrate-side reflecting face that is formed between the irradiation window and the contact window and that reflects sunlight to the solar cell element.

17. The solar cell according to claim 15,
wherein the receiver substrate has a metal base, and the reflecting member is brought into contact with the base.

18. The solar cell according to claim 15,
wherein the reflecting member includes a comb-like fin in a peripheral region of the light guide path on a side opposite to the side in contact with the receiver substrate.

19. The solar cell according to claim 15,
wherein a thickness of the resin sealing portion located directly above the solar cell element is greater than or equal to a thickness of the reflecting member.

20. The solar cell according to claim 15,
wherein a surface of the resin sealing portion is a flat face.

21. The solar cell according to claim 15,
wherein a surface of the resin sealing portion is covered with a cover member.

22. The solar cell according to claim 15,
wherein the reflecting member is made of a metal.

23. A concentrating photovoltaic power generation module comprising a concentrating lens that concentrates sunlight and a solar cell that converts sunlight concentrated by the concentrating lens into electricity,
wherein the solar cell is the solar cell according to any one of claims 15 to 22.

24. A concentrating photovoltaic power generation unit comprising an elongated frame and a plurality of concentrating photovoltaic power generation modules that are arranged along the elongated frame,
wherein the concentrating photovoltaic power generation modules are the concentrating photovoltaic power generation modules according to claim 23.

25. A solar cell manufacturing method for manufacturing a solar cell comprising a solar cell element that converts sunlight concentrated by a concentrating lens into electricity, a receiver substrate on which the solar cell element is placed, a resin sealing portion that resin-seals the solar cell element, and a reflecting member that is disposed in contact with the receiver substrate in a periphery of the solar cell element, the reflecting member having a light guide path that guides sunlight to the solar cell element and a reflecting face that defines the light guide path and that reflects sunlight to the solar cell element, the method comprising:
a reflecting member preparing step of preparing the reflecting member by molding a metal;
a reflecting member disposing step of disposing the reflecting member so as to be in contact with the receiver substrate in the periphery of the solar cell element;
a resin sealing step of forming the resin sealing portion by charging a sealing resin into the light guide path; and
a flat face forming step of forming a flat face by processing a surface of the resin sealing portion.
